# FASCICULE DE BREVET EUROPEEN

(11) **EP 1 607 761 B1**
(45) Date de publication et mention de la délivrance du brevet: **03.09.2008**
(21) Numéro de dépôt: 05360020.1
(22) Date de dépôt: 27.05.2005
(51) Int. Cl.: G01R 33/36

(54) **Circuit d'alimention multifréquencielle et sonde et spectromètre RMN comportant un tel circuit**
Multifrequenz-Stromeinspeisung und Spule und NMR-Spektrometer mit einer solchen Stromeinspeisung
Multi-frequency power supply and probe and NMR spectrometer including such a power supply

(30) Priorité: 18.06.2004 FR 0406661
(43) Date de publication de la demande: 21.12.2005
(73) Titulaire: Bruker Biospin SA, 67160 Wissembourg (FR)
(72) Inventeur: Weiss, Michel, 67240 Gries (FR); Gonella, Olivier, 67240 Bischwiller (FR); Martinache, Laurent, 67500 Marienthal (FR)
(74) Mandataire: Nuss, Laurent

(56) Documents cités:
- EP-A- 1 279 969
- US-A- 4 725 780
- MARTIN R W ET AL: "Design of a triple resonance magic angle sample spinning probe for high field solid state nuclear magnetic resonance" REVIEW OF SCIENTIFIC INSTRUMENTS, vol. 74, 2003, pages 3045-3061, XP002320221 ISSN: 0034-6748
- HOLL S M ET AL: "Rotational-echo triple-resonance NMR" JOURNAL OF MAGNETIC RESONANCE, vol. 89, 1990, pages 620-626, XP000175895 ISSN: 0022-2364

## Description

La présente invention concerne le domaine des alimentations électriques de précision, en particulier dans le domaine de la Résonance Magnétique Nucléaire, et a pour objet un circuit d'alimentation multifréquencielle d'une bobine, en particulier une bobine d'échantillon, ainsi qu'une sonde RMN et un spectromètre RMN comprenant un tel circuit.

Dans certaines applications, il est nécessaire de disposer d'une alimentation très précise en termes de caractéristiques et de propriétés des courants délivrés, ce pour des circuits utilisés dans des circonstances ou des contextes particuliers ou extrêmes.

Tel est notamment le cas pour l'alimentation des bobines d'échantillon ou RMN, situées au coeur des spectromètres RMN.

En particulier dans les expériences de RMN du solide, il est nécessaire de disposer d'un maximum de courant précisément au niveau de la région recevant l'échantillon (soumis à une rotation à plusieurs dizaines de milliers de tours par seconde), c'est-à-dire au milieu de la bobine.

Divers systèmes d'alimentation ont déjà été proposés pour répondre au besoin précité.

Toutefois, ces systèmes connus ne donnent pas entièrement satisfaction et présentent des limitations.

En effet, l'analyse multifréquencielle se généralise, d'où la nécessité de disposer de plusieurs voies d'alimentations de la bobine, à des fréquences différentes déterminées (correspondant chacune à un type de noyaux à détecter), répondant chacune à la condition de maximum de courant précité.

Les systèmes d'alimentation multifréquence proposés actuellement (voir par exemple US 5 861 748) présentent une structure très compliquée (souvent très difficile à loger aisément dans le volume cylindrique étriqué dévolu à la réception de la sonde comprenant la bobine), chaque voie d'alimentation devant comporter des moyens d'isolation par rapport aux influences des autres voies.

De plus, ces systèmes connus sont très peu souples, voire figés, en termes de variation de fréquence des différentes voies ou de changement du nombre de voies (ajout d'une voie ou suppression d'une voie). Chaque modification au niveau d'une voie se répercute au niveau de toutes les autres voies existantes dans le système et nécessite un ajustement ou des changements au niveau de ces dernières, qui eux-mêmes ont à nouveau des répercussions additionnelles, ce notamment du fait de leur structure dissymétrique.

Enfin, les systèmes d'alimentation multifréquencielle actuels sont limités, notamment pour des raisons de complexité de réalisation et de place disponible réduite, à au plus trois fréquences d'alimentation différentes et à des puissances généralement peu importantes.

Un tel système présentant trois fréquences différentes est notamment divulgué par MARTIN R. W. et al., dans "Design of a triple resonance magie angle sample spinning probe for high field solid state nuclear magnetic resonance", REVIEW OF SCIENTIFIC INSTRUMENTS, Vol. 74, 2003, pages 3045-3061.

La présente invention a pour objet de proposer une solution simple permettant de surmonter au moins certains des inconvénients précités et de dépasser certaines des limitations mentionnées.

A cet effet, l'invention a pour objet un circuit d'alimentation multifréquencielle d'une bobine, notamment d'une bobine RMN ou bobine d'échantillon, comprenant deux portions de ligne d'alimentation ou de transmission dites portions de ligne principales, ces portions de ligne principales comportant chacune au moins une portion de conducteur reliée à l'une des extrémités ou bornes de ladite bobine, ces portions de conducteur reliées constituant avec ladite bobine un circuit oscillant ou premier circuit oscillant présentant une fréquence de résonance déterminée, circuit caractérisé en ce que les portions de lignes d'alimentation ou de transmission principales consistent en des portions de ligne multi-conducteurs à impédance contrôlée, comportant chacune au moins une autre portion de conducteur non reliée à la bobine, s'étendant dans ladite portion de ligne principale à côté de la portion de conducteur reliée respectivement correspondante et présentant avec cette dernière un couplage capacitif réparti le long des segments situés côte à côte ou en regard desdits conducteurs, en ce que lesdites portions de conducteurs non reliées forment, ensemble avec la bobine et les portions de conducteur reliées et non reliées, et éventuellement avec des portions de ligne d'alimentation additionnelles raccordées auxdites portions de conducteur non reliées, au moins un circuit oscillant supplémentaire ayant une fréquence de résonance différente de celle du premier circuit oscillant, et en ce que chacun desdits circuits oscillants est bouclé sur un circuit ou composant d'accord réglable respectif, et est alimenté au moyen d'un circuit d'alimentation primaire respectif correspondant par l'intermédiaire d'un transfert d'énergie par couplage magnétique, capacitif ou magnéto-capacitif dudit circuit d'alimentation primaire concerné avec, respectivement, l'une au moins des deux portions de conducteur reliées, l'une au moins des deux portions de conducteur non reliées ou encore l'une au moins des portions de ligne additionnelles faisant partie du circuit oscillant supplémentaire concerné.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :
la figure 1 est une représentation symbolique et fonctionnelle d'une première variante d'un circuit d'alimentation à deux fréquences différentes selon l'invention ;
la figure 2 est une représentation schématique, partiellement symbolique, d'une seconde variante de réalisation d'un circuit d'alimentation à deux fréquences différentes selon l'invention ;
les figures 3 à 5 sont des représentations schématiques et partiellement symboliques de trois variantes de réalisation d'un circuit d'alimentation à trois fréquences différentes selon l'invention ;
la figure 6 est une représentation schématique d'un mode de réalisation d'un couplage magnétique variable entre un circuit oscillant et un circuit d'alimentation primaire correspondant, faisant partie d'un circuit d'alimentation selon l'invention ;
la figure 7 est une représentation schématique d'un mode de réalisation des ensembles de filtres réjecteurs faisant partie du circuit d'alimentation multifréquencielle représenté sur la figure 5 ;
les figures 8A et 8B sont des vues en perspective d'un autre mode de réalisation des capacités variables d'une paire de filtres réjecteurs faisant partie du circuit d'alimentation représenté sur la figure 5 ;
la figure 9 est une vue en perspective de la paire de capacités des figures 8A et 8B intégrées dans une partie d'une sonde RMN multifréquence selon l'invention ;
les figures 10A, 10B et 10e sont des vues respectivement en élévation latérale (fig. 10A et 10B) et en perspective (fig. 10C), à des échelles différentes, d'une sonde RMN multifréquence, pourvue d'un circuit d'alimentation selon un mode de réalisation de l'invention ;
la figure 11 est une représentation schématique, partiellement en coupe longitudinale, d'une portion de ligne principale d'alimentation ou de transmission sous la forme d'une portion de ligne triaxiale ou à trois conducteurs concentriques, pouvant faire partie d'un circuit d'alimentation multifréquencielle selon l'invention, et,
la figure 12 est une représentation schématique, en coupe transversale, d'une portion de ligne principale d'alimentation ou de transmission sous la forme d'une portion de ligne stratifié ou à couches (avec des portions de conducteur en bandes), pouvant faire partie d'un circuit d'alimentation multifréquencielle selon l'invention.

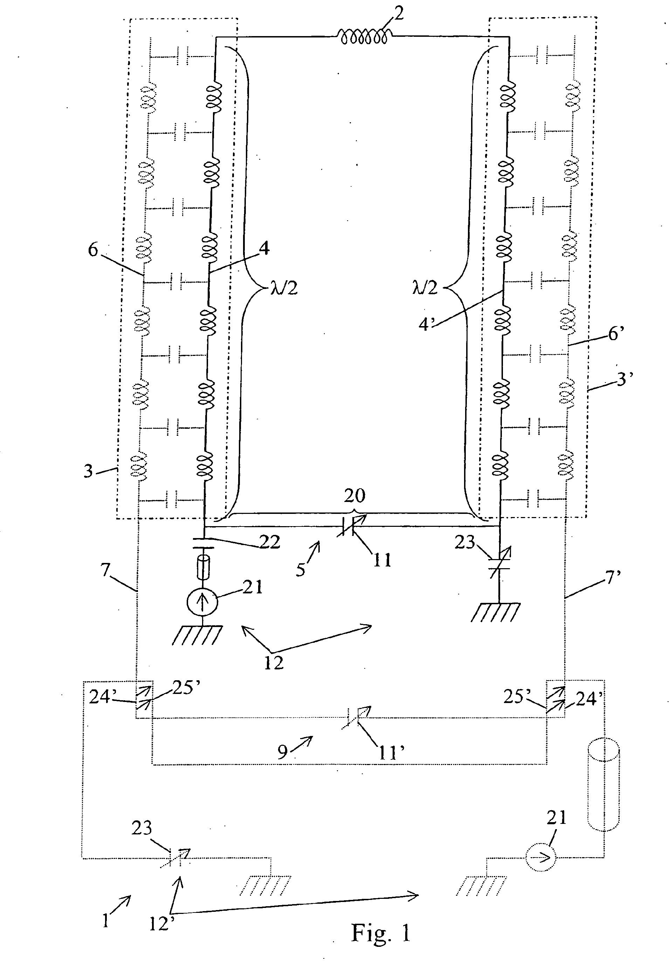

Les figures 1 à 5 montrent chacune un circuit 1 d'alimentation multifréquencielle d'une bobine 2, notamment d'une bobine RMN ou bobine d'échantillon, comprenant deux portions de ligne d'alimentation ou de transmission 3 et 3' dites portions de ligne principales, ces portions de ligne principales 3, 3' comportant chacune au moins une portion de conducteur 4, 4' reliée à l'une des extrémités ou bornes de ladite bobine 2, ces portions de conducteur reliées 4, 4' constituant avec ladite bobine 2 un circuit oscillant ou premier circuit oscillant présentant une fréquence de résonance déterminée.

Conformément à l'invention, les portions de lignes d'alimentation ou de transmission principales 3, 3' consistent en des portions de ligne multi-conducteurs à impédance contrôlée, comportant chacune au moins une autre portion de conducteur 6, 6' non reliée à la bobine 2, s'étendant dans ladite portion de ligne principale 3, 3' à côté de la portion de conducteur 4, 4' reliée respectivement correspondante et présentant avec cette dernière un couplage capacitif réparti le long des segments situés côte à côte ou en regard desdits conducteurs 4, 4' et 6, 6'. De plus, lesdites portions de conducteurs 6, 6' non reliées forment, ensemble avec la bobine 2 et les portions de conducteur reliées 4, 4' et non reliées 6, 6', et éventuellement avec des portions de ligne d'alimentation 7, 7' ; 8, 8' additionnelles raccordées auxdites portions de conducteur 6, 6' non reliées, au moins un circuit oscillant supplémentaire 9, 10 ayant une fréquence de résonance différente de celle du premier circuit oscillant 5. En outre, chacun desdits circuits oscillants 5, 9, 10 est bouclé sur un circuit ou composant d'accord réglable respectif 11, 11', 11 ", et est alimenté au moyen d'un circuit d'alimentation primaire 12, 12', 12" respectif correspondant par l'intermédiaire d'un transfert d'énergie par couplage magnétique, capacitif ou magnéto-capacitif dudit circuit d'alimentation primaire 12, 12', 12" concerné avec, respectivement, l'une au moins des deux portions de conducteur 4, 4' reliées, l'une au moins des deux portions de conducteur 6, 6' non reliées ou encore l'une au moins des portions de ligne additionnelles 7, 7' ; 8, 8' faisant partie du circuit oscillant supplémentaire 9, 10 concerné.

La capacité fournit par le couplage capacitif entre conducteurs reliés 4, 4' et non reliées 6, 6' étant intégrée dans le ou les circuit(s) supplémentaire(s) 9, 10 relié(s) aux et comprenant les portions de conducteur non reliés 6, 6', le circuit ou composant d'accord 11', 11" de ce ou de chacun de ces circuit(s) 9, 10 pourra être dimensionné en conséquence (nécessité d'une capacité d'accord de moindre valeur /réduction des performances et donc réduction de l'encombrement et des coûts de revient).

Selon une caractéristique importante de l'invention, et comme cela ressort des figures 1 à 5, chaque circuit oscillant 5, 9, 10 présente une structure et une constitution symétriques intégrant des portions de conducteur reliées 4, 4' et éventuellement des portions de conducteur non reliées 6, 6', ainsi que des portions de ligne additionnelles 7, 7' ; 8, 8', respectivement de types et de longueurs identiques deux par deux, les deux portions de conducteurs reliées 4, 4' faisant partie du premier circuit oscillant 5 présentant une longueur multiple de la demi-longueur d'onde de résonance dudit premier circuit oscillant 5.

Par l'expression "structure et constitution symétriques", appliquée aux circuits oscillants faisant partie du circuit d'alimentation 1, il y a lieu de comprendre dans la présente que chaque circuit oscillant présente électriquement, et également physiquement, une structure symétrique par rapport au centre de la bobine 2. Chaque circuit oscillant est bouclé, d'une part, sur cette bobine 2 et, d'autre part, sur un circuit ou composant d'accord symétrique réglable 11, 11', 11" propre à ce circuit, en comprenant deux branches identiques.

Préférentiellement, le ou les circuit(s) oscillant(s) supplémentaire(s) 9, 10 présente(nt) une ou des fréquence(s) de résonance plus élevée(s) que celle du premier circuit oscillant 5, la longueur des segments mutuellement en regard respectivement des portions de conducteur reliées 4, 4' et non reliées 6, 6' de deux portions de ligne principales 3, 3' étant suffisante pour que le degré ou niveau de couplage résultant de la capacité linéique répartie le long desdites portions de lignes assure un transfert d'énergie suffisant pour la ou les fréquence(s) de résonance dudit ou desdits circuit(s) oscillant(s) supplémentaire(s) 9, 10.

Afin d'éviter toute interférence ou perturbation extérieure au niveau des portions de ligne principales 3 et 3', ces dernières comportent avantageusement au moins un revêtement ou conducteur d'isolation 13, formant blindage autour des portions de conducteur reliées et non reliées, entre ces dernières et l'extérieur.

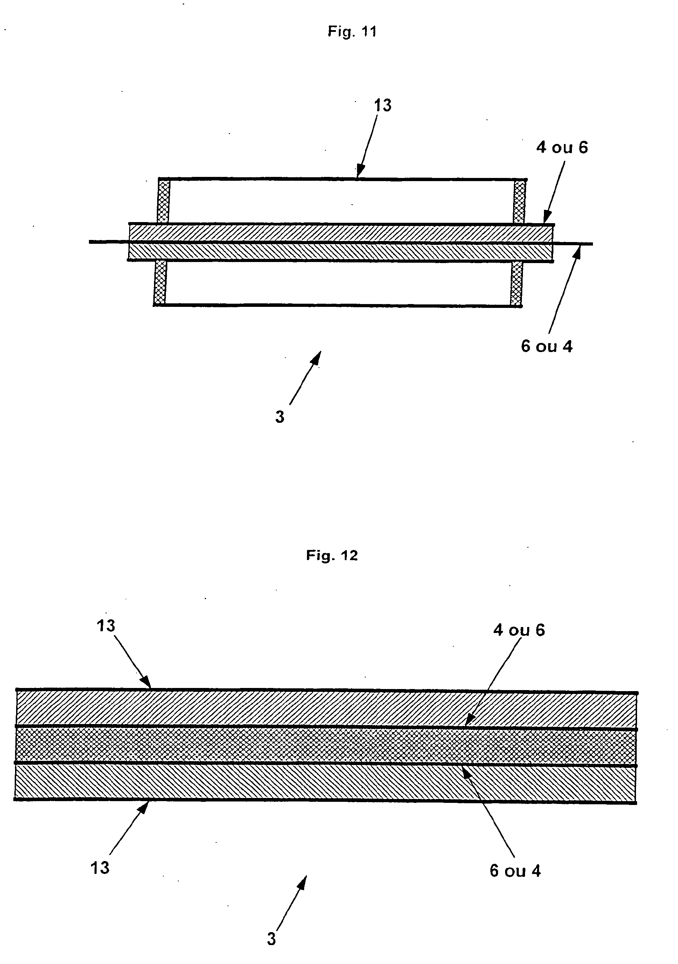

Selon un premier mode de réalisation pratique des portions de ligne de transmission ou d'alimentation 3 et 3', représenté sur la figure 12 des dessins annexés, les conducteurs 4, 4' ; 6, 6' de ces portions de ligne 3, 3' peuvent consister en des conducteurs en bande assemblés, avec interposition de matériau diélectrique, en des lignes à structure stratifiée ou en sandwich, préférentiellement de constitution flexible, les portions de ligne d'alimentation 7, 7' ; 8, 8' additionnelles consistant préférentiellement en des lignes coaxiales.

Ces conducteurs en bande sont séparés par des couches de matériau diélectrique dont la nature et l'épaisseur détermine le degré de couplage capacitif entre eux.

Selon un second mode de réalisation pratique préféré desdites portions de ligne principales 3 et 3', représenté sur la figure 11 des dessins annexés, les conducteurs 4, 4' ; 6, 6' desdites portions de ligne d'alimentation ou de transmission principales 3, 3' consistent en des conducteurs concentriques et coaxiaux, avec un conducteur filaire central et un ou plusieurs conducteurs tubulaires concentriques entourant ce conducteur filaire, avec interposition de couches diélectriques, les portions de ligne d'alimentation 7, 7' ; 8, 8' additionnelles consistant préférentiellement en des lignes coaxiales.

Les conducteurs concentriques sont également séparés par des couches diélectriques de natures et/ou d'épaisseurs différentes.

Ainsi, la couche séparant le conducteur filaire central du premier conducteur tubulaire concentrique pourra, par exemple, consister en un polymère (polytétrafluoroéthylène) et la couche séparant ce premier conducteur tubulaire d'un second conducteur tubulaire concentrique, en un autre polymère ou de l'air.

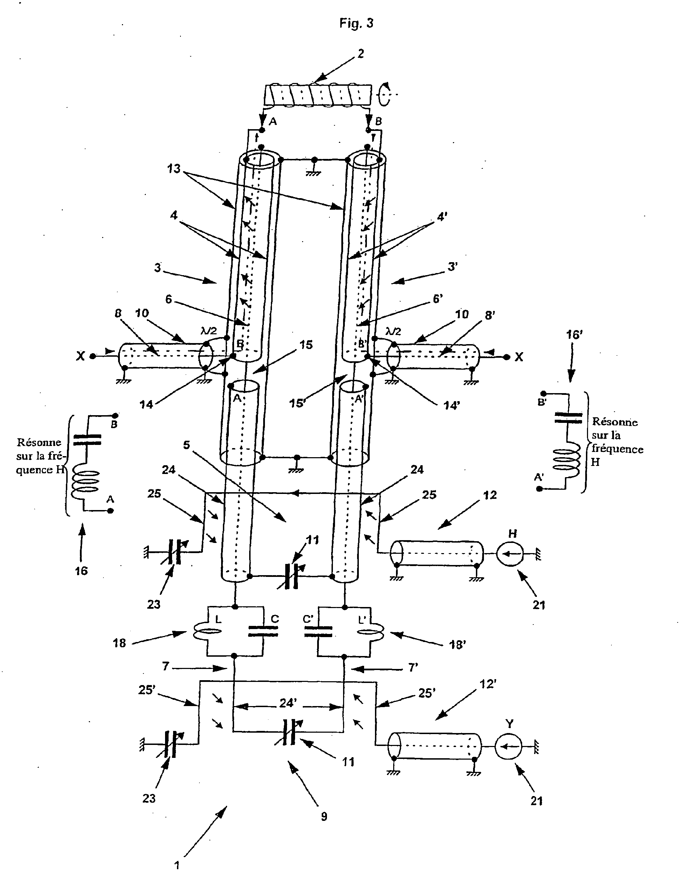

Conformément à un premier mode de réalisation très avantageux de l'invention, représenté des figures 3, 4 et 5 des dessins annexés, le circuit d'alimentation 1 comprend, en plus du premier circuit oscillant 5 et d'un premier circuit oscillant supplémentaire 9, au moins un autre circuit oscillant supplémentaire 10 à structure symétrique avec une fréquence de résonance différente de celles des circuits oscillants 5 et 9 précités et constitué par la bobine RMN 2, par des parties des portions de conducteur reliées 4, 4' des portions de ligne principales 3, 3', et par des portions de ligne de transmission additionnelles 8, 8' propres audit autre(s) circuit(s) oscillant(s) 10. Ces deux ensembles [portion de ligne propre 8, 8' /partie de portion de conducteur reliée 4, 4' consécutive] présentent des longueurs cumulées identiques et égales à un multiple de la demi-longueur d'onde de résonance de cet (ces) autre(s) circuit(s) 10, et ces portions de lignes propres 8, 8' sont bouclées sur un circuit ou composant d'accord réglable 11" à structure symétrique au niveau d'une de leurs extrémités et raccordées par leurs autres extrémités chacun à l'une des portions de conducteur reliées 4, 4' des portions de ligne principales 3, 3', au niveau d'un point froid non interférent 14 ou 14' de la portion de conducteur reliée (4 ou 4') concernée.

Conformément à un second mode de réalisation très avantageux de l'invention, le circuit d'alimentation comprend, en plus du premier circuit oscillant 5 et d'un premier circuit oscillant supplémentaire 9, au moins un autre circuit oscillant supplémentaire 10 à structure symétrique avec une fréquence de résonance différente de celles des circuits oscillants 5 et 9 précités. Cet ou ces autre(s) circuit(s) oscillant(s) 10 est (sont) alors principalement constitué(s) par des portions de ligne de transmission 8, 8' propres audit autre circuit 10, bouclées sur un circuit ou composant d'accord réglable 11" à structure symétrique au niveau de l'une des extrémités de chacune desdites portions de ligne propres 8, 8' et raccordées par leur autre extrémité chacune à l'une des portions de conducteur non reliées 6, 6' des portions de ligne de transmission ou d'alimentation principales 3, 3'.

Ainsi, il est possible de multiplier les circuits oscillants faisant partie du circuit d'alimentation 1, sans avoir à modifier la constitution ou à ajuster les paramètres des circuits oscillants faisant déjà partie de ce circuit d'alimentation, ce sans altérer les voies d'alimentation fournies par ces dernières, ni la structure et le comportement symétriques d'ensemble (assurant un maximum de courant au niveau du centre de la bobine 2).

L'invention fournit ainsi une possibilité de réaliser un circuit d'alimentation à voies multiples, de type gigogne et n'altérant pas la structure de circuit existante lors de l'ajout d'un circuit oscillant (donc d'une voie d'alimentation) supplémentaire, notamment au niveau des portions de lignes principales 3 et 3' (Ces dernières et la bobine 2 faisant partie de chacun des circuits oscillants 5, 9, 10).

Généralement, les analyses spectrométriques nécessitent la fourniture de trois fréquences d'excitation différentes pour la détection de trois types de noyaux. Ces trois canaux de fréquences comprennent généralement une fréquence élevée correspondant à la résonance du noyau H (proton - dénommé canal H) et deux autres canaux englobant les noyaux résonants dans un bande de fréquences plus basses. Cette bande de fréquences plus basses est divisée en deux sous-bandes, la sous-bande Y correspondant à une sous-bande basse et la sous-bande X correspondant à la sous-bande haute (dénommées respectivement canal Y et canal X).

Sur les figures des dessins annexés, certaines indications supplémentaires (en plus des références numériques) permettent d'identifier les composants ou parties de circuit appartenant ou participant aux voies d'alimentation de ces trois canaux.

Avantageusement, et en relation avec une réalisation pratique simple, les portions de ligne multiconducteurs 3, 3' constituant les portions de ligne d'alimentation ou de transmission principales comprennent chacune, en plus du ou d'un revêtement ou conducteur de blindage 13, une première portion de conducteur 4, 4' reliée à la bobine 2 et une seconde portion de conducteur 6, 6' non reliée à la bobine 2 et couplée de manière capacitive à ladite première portion de conducteur 4, 4'.

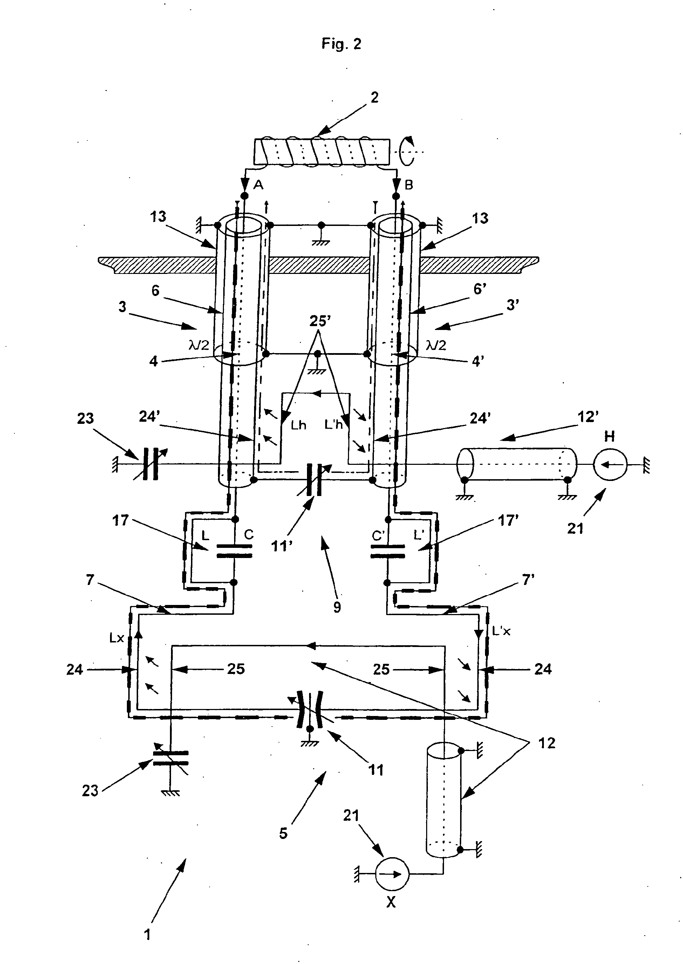

Préférentiellement, comme cela ressort schématiquement des figures 2 à 5, et comme représenté plus précisément sur la figure 11 à titre d'exemple de réalisation, les portions de ligne multiconducteur 3 et 3' peuvent consister en des portions de ligne triaxiale ou à trois conducteurs concentriques 4, 6, 13 ; 4', 6', 13', au moins le premier circuit oscillant 5 intégrant les portions de conducteur 4, 4' reliées directement à la bobine 2 desdites lignes triaxiales 3, 3' et ledit au moins un circuit oscillant supplémentaire 9 intégrant les portions de conducteur concentriques supplémentaires non reliées 6, 6' desdites lignes triaxiales 3, 3', un transfert d'énergie s'effectuant entre ces conducteurs concentriques respectivement associés, du fait de la capacité linéique répartie desdites lignes triaxiales 3, 3'.

Comme le montre la figure 11, chaque portion de ligne 3, 3' peut être composée par exemple d'un câble coaxial monté soit dans un tube métallique, soit en lieu et place du conducteur central d'un câble coaxial de plus grand diamètre.

En accord avec une première variante, les portions de conducteur 4, 4' reliées directement à la bobine 2 des lignes triaxiales 3, 3' sont constitués par les conducteurs intermédiaires de ces dernières et ledit au moins un circuit oscillant supplémentaire 9 comprend les portions de conducteur central 6, 6' non reliées à la bobine 2, la capacité linéique répartie entre les conducteurs centraux et intermédiaires fournissant une connexion par couplage permettant audit au moins un circuit oscillant supplémentaire considéré 9 de se boucler sur la bobine 2 par l'intermédiaire desdits conducteurs intermédiaires 4, 4' reliés à celle-ci (figure 3).

Dans ce dernier cas, il peut être prévu que les portions de conducteur intermédiaire 4, 4' présentent chacun une coupure ou discontinuité physique 15, 15' au niveau d'un point froid non interférent respectif et que les portions de lignes additionnelles 8, 8' dudit au moins un autre circuit oscillant supplémentaire 10 soient reliées au niveau desdits points froids auxdites portions de conducteur intermédiaires 4, 4' reliées à la bobine 2, les deux parties desdites portions de conducteur intermédiaires 4, 4' mutuellement en regard au niveau de ladite coupure ou discontinuité 15, 15' étant reliées entre elles par des circuits de transfert d'énergie 16, 16' sélectifs en fréquence, par exemple des filtres passe-bande centrés sur la fréquence de résonance du premier circuit oscillant 5 et transmettant le maximum d'énergie pour cette fréquence.

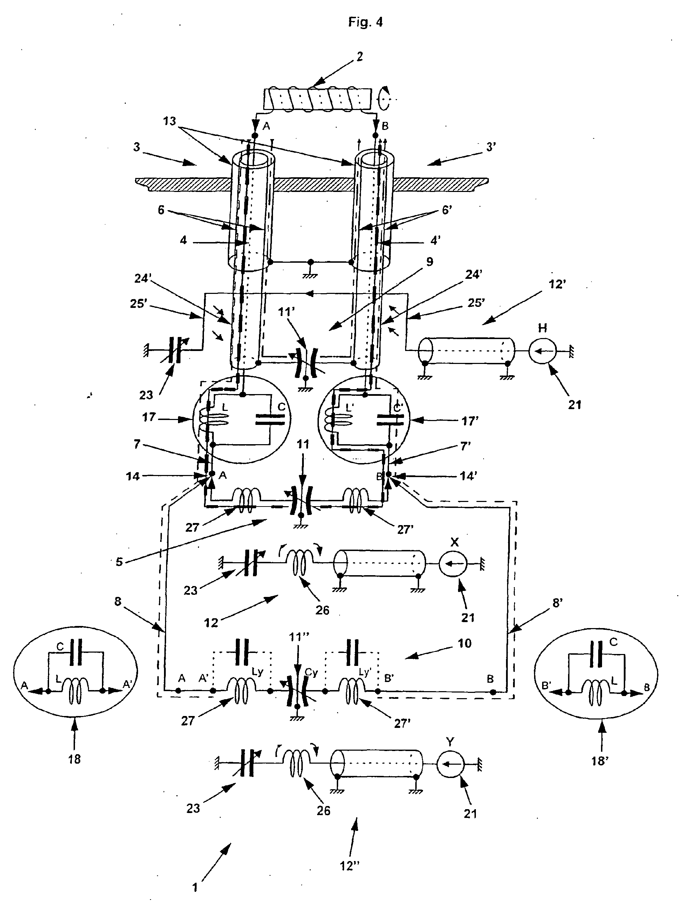

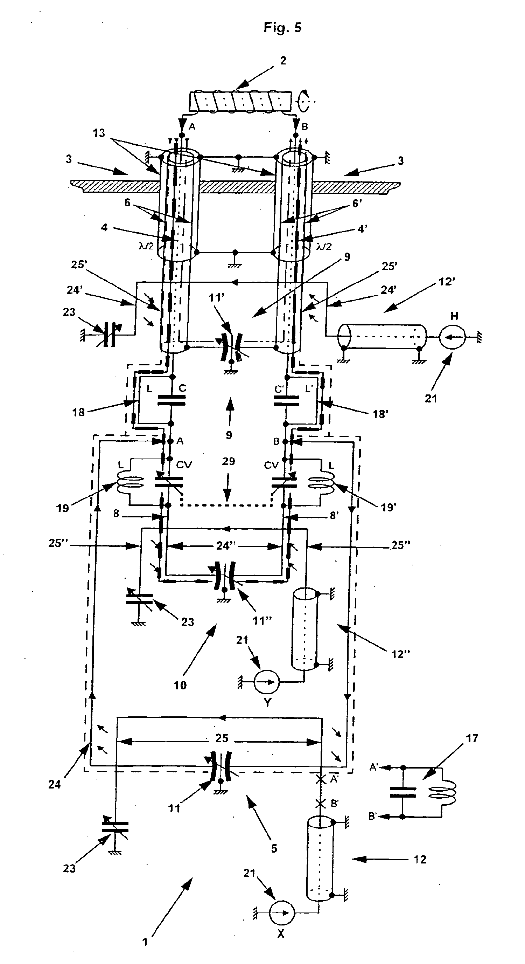

En accord avec une seconde variante, les portions de conducteur 4, 4' reliées directement à la bobine 2 des lignes triaxiales sont constitués par les portions de conducteur central de ces dernières et en ce que ledit au moins un circuit oscillant supplémentaire 9 intègre les portions de conducteur intermédiaire 6, 6' non reliées à la bobine 2, la capacité linéique répartie entre ces conducteurs centraux et intermédiaires fournissant une connexion par couplage permettant audit au moins un circuit oscillant supplémentaire 9 considéré de se boucler sur la bobine 2 par l'intermédiaire des conducteurs centraux 4, 4' reliés à celle-ci. (figures 4 et 5).

Dans ce dernier cas, il peut être prévu que les conducteurs des portions de lignes additionnelles 8, 8' dudit au moins un autre circuit oscillant supplémentaire 10 soient reliés aux conducteurs centraux 4, 4' au niveau de points froids non interférents 14, 14' de ces conducteurs, et que des filtres réjecteurs 17, 17' isolent entre eux le premier circuit oscillant 5 et le ou les autre(s) circuit(s) oscillant(s) supplémentaire(s) 10 dont les portions de lignes additionnelles 8, 8' sont reliées auxdits conducteurs centraux. Ces derniers circuits oscillants 5, 10 sont également isolés dudit au moins un circuit oscillant supplémentaire 9 intégrant les conducteurs intermédiaires non reliés à la bobine, par des filtres réjecteurs adaptés 18, 18' ; 19, 19'.

Les différents circuits oscillants 5, 9, 10 peuvent être alimentés soit de manière directe (par liaison galvanique), soit de manière indirecte (par couplage).

Ainsi, conformément à une première possibilité de réalisation, représentée à la figure 1, le circuit d'alimentation primaire 12, 12', 12" de l'un au moins des circuits oscillants 5, 9, 10 est partiellement confondu avec ce circuit oscillant en intégrant une partie de circuit commune 20 avec ce circuit oscillant, et ledit circuit d'alimentation primaire 12, 12', 12" comprend, d'une part, un générateur radiofréquence 21 ajusté à la fréquence de résonance déterminée du circuit oscillant associé 5, 9, 10 et relié audit circuit oscillant au niveau d'une borne du circuit ou composant d'accord symétrique réglable correspondant 11, 11', 11" par l'intermédiaire d'une capacité de couplage 22 et, d'autre part, un circuit ou composant d'adaptation 23 relié à l'autre borne dudit circuit ou composant d'accord symétrique réglable, le composant d'adaptation 23 et le composant d'accord symétrique réglable 11, 11', 11" faisant partie des deux circuits 12, 12', 12" et 5, 9, 10, consistant en des capacités et le générateur 21 pouvant fonctionner de manière continue, par intermittence ou pulsée.

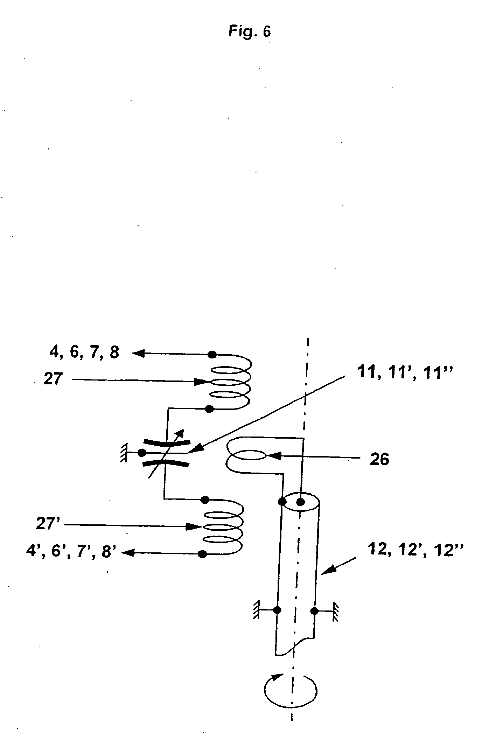

Conformément à une seconde possibilité de réalisation, ressortant des figures 2 à 6, le circuit d'alimentation primaire 12, 12', 12" de l'un au moins des circuits oscillants 5, 9, 10 consiste en un circuit séparé et comprend, en plus d'un générateur radiofréquence 21 ajusté à la fréquence de résonance déterminée du circuit oscillant concerné et du ou des éléments participant au couplage avec l'un au moins des deux portions de conducteur 4, 4' reliée à la bobine 2 d'une ou des portions de ligne principales 3, 3' et au circuit ou composant d'accord 11, 11', 11 ", également un circuit ou composant d'adaptation 23 destiné à optimiser le couplage et à en limiter certains effets au niveau dudit circuit d'alimentation primaire.

En relation avec cette seconde possibilité, le ou chaque couplage [circuit d'alimentation primaire 12, 12', 12" / circuit oscillant correspondant 5, 9, 10 concerné] est un couplage essentiellement de nature magnétique et le circuit ou composant d'adaptation 23 est une capacité réglable destinée à annuler la réactance inductive au niveau du circuit d'alimentation primaire considéré.

Avantageusement, et pour préserver la symétrie d'ensemble, le transfert d'énergie par couplage entre un circuit d'alimentation primaire 12, 12', 12" et le circuit oscillant associé 5, 9, 10 consiste en un couplage double et affecte de manière symétrique et équivalente les portions de conducteur 4, 4' ; 6, 6' similaires des deux portions de ligne de transmission 3, 3' ; 8, 8' ; 7, 7' concernées.

Comme représenté sur les figures 2, 3 et 5 et selon une première variante de réalisation pratique du couplage 5, 9, 10 / 12, 12', 12", le ou chacun des deux couplage(s) [circuit d'alimentation primaire 12, 12', 12" / circuit oscillant correspondant concerné 5, 9, 10] réalisant le transfert d'énergie entre ces deux circuits peut consister en un couplage principalement magnétique entre, d'une part, un segment 24, 24', 24" d'une portion de conducteur d'une des portions de ligne 3, 3' ; 7, 7' ; 8, 8' du circuit oscillant considéré 5, 9, 10 et, d'autre part, un segment en regard 25, 25', 25" de la ligne reliant le générateur 21 au composant d'adaptation 23 dans le circuit d'alimentation primaire 12, 12', 12" associé, les deux segments de chacune de ces paires de segments mutuellement associés 24, 25 ; 24', 25' ; 24", 25" présentant des longueurs déterminées et étant disposés parallèlement et à proximité l'un de l'autre de manière à former des lignes de Lecher.

Comme représenté sur les figures 4 à 6 et selon une seconde variante de réalisation pratique du couplage 5, 9, 10 / 12, 12', 12", le ou chaque couplage à transfert d'énergie [circuit d'alimentation primaire 12, 12', 12" / circuit oscillant correspondant concerné 5, 9, 10] peut consister en un couplage magnéto-capacitif, symétrique ou asymétrique, entre, d'une part, un solénoïde 26 monté en série dans ledit circuit d'alimentation primaire 12, 12', 12" et, d'autre part, un ensemble capacité/inductance(s) monté en série dans le circuit oscillant 5, 9, 10 concerné associé, ladite capacité pouvant correspondre au composant d'accord 11, 11', 11" et les inductances 27 et 27' comprendre deux inductances équivalentes montées en série de part et d'autre de ladite capacité d'accord, en faisant éventuellement partie chacune d'un circuit LC.

En vue d'isoler les voies susceptibles d'être perturbées par une ou plusieurs autres voies, il est avantageusement prévu que le premier circuit oscillant 5 et/ou ledit au moins un circuit oscillant supplémentaire 9, 10 intègrent un ou des filtres d'isolation réjecteurs de bande 17, 17' ; 18, 18' ; 19, 19' ajustés, le cas échéant chacun, sur la fréquence de résonance de l'autre ou de l'un des autres circuits oscillant(s).

Préférentiellement, les filtres d'isolation se présentent sous la forme de paire(s) de filtres disposées symétriquement dans le circuit oscillant concerné, chaque filtre d'une paire donnée de filtres étant relié en série à ou monté en série avec l'une des portions de conducteur faisant partie dudit circuit oscillant concerné.

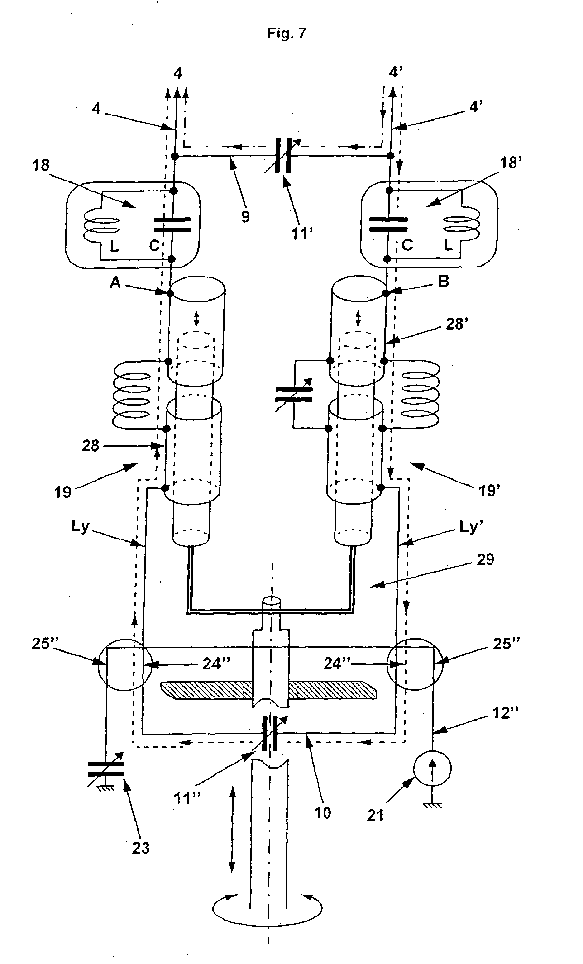

Comme le montrent les figures 5 et 7 des dessins annexés, et en présence d'un premier circuit oscillant 5 et de deux circuits oscillants supplémentaires 9 et 10, au moins l'un 10 desdits circuits oscillants intègre deux paires de filtres d'isolation 17, 17' ; 18, 18' ; 19, 19', chaque paire de filtres étant ajustée sur la fréquence de résonance de l'un des deux autres circuits oscillants 5 et 9, l'une 19, 19' des paires de filtres au moins étant réglable en fréquence, préférentiellement de manière continue.

Dans ce dernier cas, ces filtres peuvent consister en des paires de circuits LC, la ou les paire(s) de filtres 19, 19' éventuellement réglable(s) en fréquence intégrant des capacités variables 28, 28' de manière continue avec un asservissement mécanique mutuel de leur réglage 29.

Les capacités variables 28 peuvent par exemple consister en un élément mobile solidaire d'une des bornes de la capacité et un élément fixe solidaire de l'autre borne, les éléments mobiles des deux capacités 28 étant physiquement et/ou cinématiquement mutuellement reliés de manière à être déplacés simultanément de la même amplitude de mouvement. Le déplacement relatif des éléments mobiles par rapport aux éléments fixes variant la valeur de la capacitance desdits capacités variables 28.

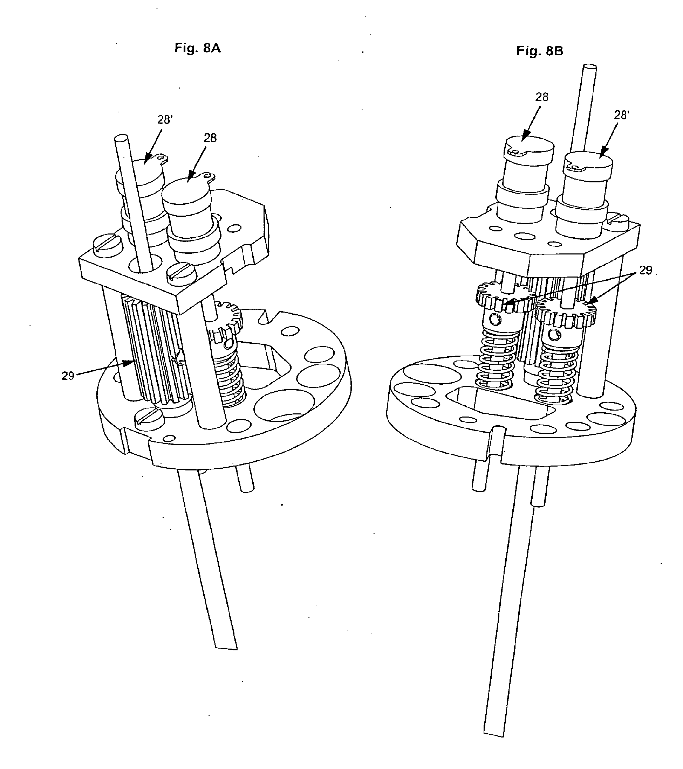

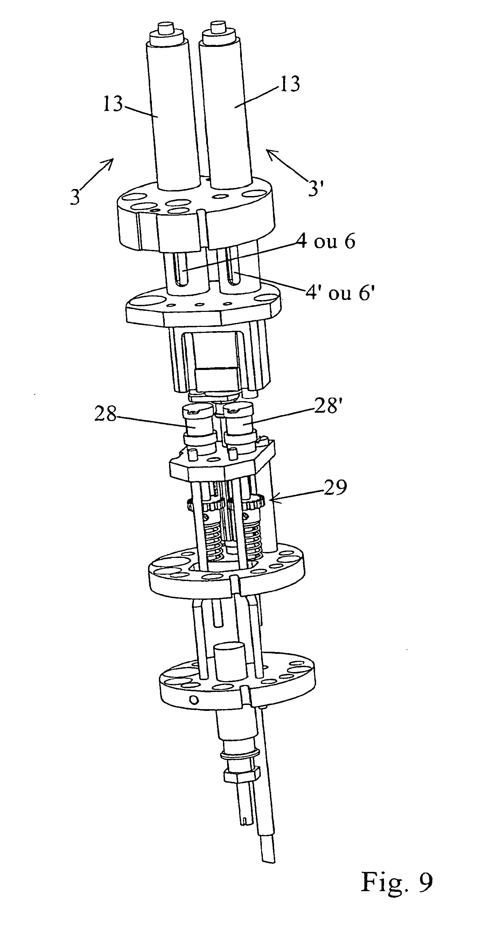

Ledit déplacement pourra consister en un mouvement de translation (Fig. 7), l'élément mobile formant ainsi un plongeur mobile dans le cylindre creux formé par l'élément fixe et les deux plongeurs étant reliés mécaniquement par une barre de connexion rigide solidaire d'un organe de déplacement (vis millimétrique par exemple). Le déplacement pourra également consister en une rotation (Fig. 8A, 8B et 9), les deux éléments mobiles étant alors montés sur des axes tournants pourvus de pignons dentés, lesquels sont entraînés de concert par un pignon menant solidaire d'une tige de commande.

Grâce à l'invention, il est donc possible de fournir une alimentation avec un maximum d'intensité toujours situé exactement au milieu de la bobine 2, ce quelle que soit la fréquence d'excitation concernée.

En outre, l'ajout d'un circuit oscillant supplémentaire (à structure symétrique), associé à une fréquence de résonance correspondante, n'a sensiblement aucune influence sur les circuits oscillants faisant déjà partie du circuit d'alimentation, et en particulier n'entraîne aucune dissymétrie dans ces circuits existants.

Par ailleurs, les portions de ligne de transmission 3 et 3' utilisées par tous les circuits oscillants 5, 9, 10 (et au moins en partie communes à ces derniers), ne sont pas modifiées et ne font l'objet d'aucune opération de réglage, même lors du rajout d'un nouveau circuit oscillant.

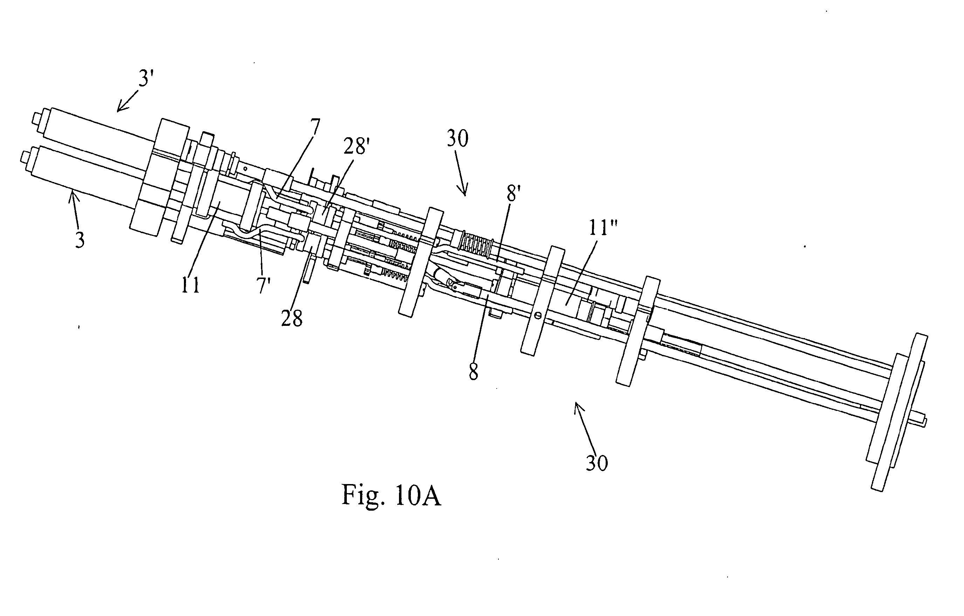

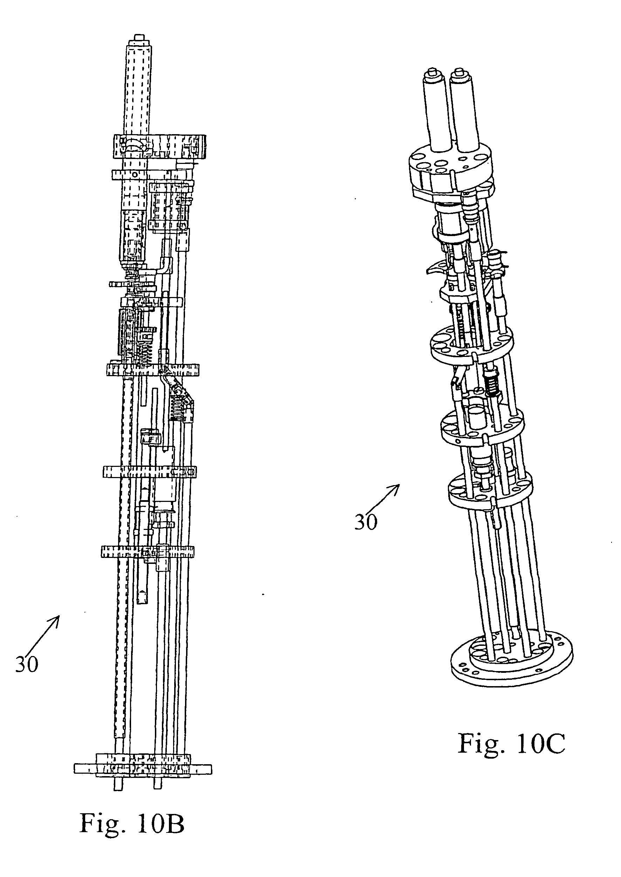

L'invention a également pour objet une sonde RMN 30 multifréquence, caractérisée en ce qu'elle comprend, au moins en partie, un circuit d'alimentation 1 de la bobine d'échantillon 2 présentant au moins certaines des caractéristiques exposées ci-dessus (Fig. 10A, 10B et 10C).

Enfin, l'invention couvre également un spectromètre RMN, en particulier pour spectrométrie en phase solide, caractérisé en ce qu'il comprend un circuit d'alimentation 1 de la bobine d'échantillon 2 tel que décrit ci-dessus et une sonde du type mentionné précédemment.

## Revendications

1. Circuit d'alimentation multifréquencielle d'une bobine, notamment d'une bobine RMN ou bobine d'échantillon, comprenant deux portions de ligne d'alimentation ou de transmission dites portions de ligne principales, ces portions de ligne principales comportant chacune au moins une portion de conducteur reliée à l'une des extrémités ou bornes de ladite bobine, ces portions de conducteur reliées constituant avec ladite bobine un circuit oscillant ou premier circuit oscillant présentant une fréquence de résonance déterminée, circuit (1) **caractérisé en ce que** les portions de lignes d'alimentation ou de transmission principales (3, 3') consistent en des portions de ligne multi-conducteurs à impédance contrôlée, comportant chacune au moins une autre portion de conducteur (6, 6') non reliée à la bobine (2), s'étendant dans ladite portion de ligne principale (3, 3') à côté de la portion de conducteur (4, 4') reliée respectivement correspondante et présentant avec cette dernière un couplage capacitif réparti le long des segments situés côte à côte ou en regard desdits conducteurs (4, 4' et 6, 6'), **en ce que** lesdites portions de conducteurs (6, 6') non reliées forment, ensemble avec la bobine (2) et les portions de conducteur reliées (4, 4') et non reliées (6, 6'), et éventuellement avec des portions de ligne d'alimentation (7, 7' ; 8, 8') additionnelles raccordées auxdites portions de conducteur (6, 6') non reliées, au moins un circuit oscillant supplémentaire (9, 10) ayant une fréquence de résonance différente de celle du premier circuit oscillant (5), et **en ce que** chacun desdits circuits oscillants (5, 9, 10) est bouclé sur un circuit ou composant d'accord réglable respectif (11, 11', 11"), et est alimenté au moyen d'un circuit d'alimentation primaire (12, 12', 12") respectif correspondant par l'intermédiaire d'un transfert d'énergie par couplage magnétique, capacitif ou magnéto-capacitif dudit circuit d'alimentation primaire (12, 12', 12") concerné avec, respectivement, l'une au moins des deux portions de conducteur (4, 4') reliées, l'une au moins des deux portions de conducteur (6, 6') non reliées ou encore l'une au moins des portions de ligne additionnelles (7, 7' ; 8, 8') faisant partie du circuit oscillant supplémentaire (9, 10) concerné.

2. Circuit d'alimentation selon la revendication 1, **caractérisé en ce que** chaque circuit oscillant (5, 9, 10) présente une structure et une constitution symétriques intégrant des portions de conducteur reliées (4, 4') et éventuellement des portions de conducteur non reliées (6, 6'), ainsi que des portions de ligne additionnelles (7, 7' ; 8, 8'), respectivement de types et de longueurs identiques deux par deux, les deux portions de conducteurs reliées (4, 4') faisant partie du premier circuit oscillant (5) présentant une longueur multiple de la demi-longueur d'onde de résonance dudit premier circuit oscillant (5).

3. Circuit d'alimentation selon l'une quelconque des revendications 1 et 2, **caractérisé en ce que** le ou les circuit(s) oscillant(s) supplémentaire(s) (9, 10) présente(nt) une ou des fréquence(s) de résonance plus élevée(s) que celle du premier circuit oscillant (5), la longueur des segments mutuellement en regard respectivement des portions de conducteur reliées (4, 4') et non reliées (6, 6') de deux portions de ligne principales (3, 3') étant suffisante pour que le degré ou niveau de couplage résultant de la capacité linéique répartie le long desdites portions de lignes assure un transfert d'énergie suffisant pour la ou les fréquence(s) de résonance dudit ou desdits circuit(s) oscillant(s) supplémeritaire(s) (9, 10).

4. Circuit d'alimentation selon l'une quelconque des revendications 1 à 3, **caractérisé en ce que** les deux portions de ligne principales d'alimentation ou de transmission (3 et 3') comportent au moins un revêtement ou conducteur d'isolation (13), formant blindage autour des portions de conducteur reliées et non reliées, entre ces dernières et l'extérieur.

5. Circuit d'alimentation selon l'une quelconque des revendications 1 à 4, **caractérisé en ce que** les conducteurs (4, 4' ; 6, 6') des portions de ligne d'alimentation ou de transmission principales (3, 3') consistent en des conducteurs en bande assemblés, avec interposition de matériau diélectrique, en des lignes à structure stratifiée ou en sandwich, préférentiellement de constitution flexible, les portions de ligne d'alimentation (7, 7' ; 8, 8') additionnelles consistant préférentiellement en des lignes coaxiales.

6. Circuit d'alimentation selon l'une quelconque des revendications 1 à 4, **caractérisé en ce que** les conducteurs (4, 4' ; 6, 6') des portions de ligne d'alimentation ou de transmission principales (3, 3') consistent en des conducteurs concentriques et coaxiaux, avec un conducteur filaire central et un ou plusieurs conducteurs tubulaires concentriques entourant ce conducteur filaire, avec interposition de couches diélectriques, les portions de ligne d'alimentation (7, 7' ; 8, 8') additionnelles consistant préférentiellement en des lignes coaxiales.

7. Circuit d'alimentation selon l'une quelconque des revendications 1 à 6, **caractérisé en ce qu'**il comprend, en plus du premier circuit oscillant (5) et d'un premier circuit oscillant supplémentaire (9), au moins un autre circuit oscillant supplémentaire (10) à structure symétrique avec une fréquence de résonance différente de celles des circuits oscillants (5 et 9) précités et constitué par la bobine RMN (2), par des parties des portions de conducteur reliées (4, 4') des portions de ligne principales (3, 3'), et par des portions de ligne de transmission additionnelles (8, 8') propres audit autre(s) circuit(s) oscillant(s) (10), **en ce que** ces deux ensembles [portion de ligne propre (8, 8') / partie de portion de conducteur reliée (4, 4') consécutive] présentent des longueurs cumulées identiques et égales à un multiple de la demi-longueur d'onde de résonance de cet (ces) autre(s) circuit(s) (10), et **en ce que** ces portions de lignes propres (8, 8') sont bouclées sur un circuit ou composant d'accord réglable (11") à structure symétrique au niveau d'une de leurs extrémités et raccordées par leurs autres extrémités chacun à l'une des portions de conducteur reliées (4, 4') des portions de ligne principales (3, 3'), au niveau d'un point froid non interférent (14 ou 14') de la portion de conducteur reliée (4 ou 4') concernée.

8. Circuit d'alimentation selon l'une quelconque des revendications 1 à 6, **caractérisé en ce qu'**il comprend, en plus du premier circuit oscillant (5) et d'un premier circuit oscillant supplémentaire (9), au moins un autre circuit oscillant supplémentaire (10) à structure symétrique avec une fréquence de résonance différente de celles des circuits oscillants (5 et 9) précités, et **en ce que** cet ou ces autre(s) circuit(s) oscillant(s) (10) est (sont) principalement constitué par des portions de ligne de transmission (8, 8') propres audit autre circuit (10), bouclées sur un circuit ou composant d'accord réglable (11") à structure symétrique au niveau de l'une des extrémités de chacune desdites portions de ligne propres (8, 8') et raccordées par leur autre extrémité chacune à l'une des portions de conducteur non reliées (6, 6') des portions de ligne de transmission ou d'alimentation principales (3, 3').

9. Circuit d'alimentation selon l'une quelconque des revendications 1 à 8, **caractérisé en ce que** les portions de ligne multiconducteurs (3, 3') constituant les portions de ligne d'alimentation ou de transmission principales comprennent chacune, en plus du ou d'un revêtement ou conducteur de blindage (13), une première portion de conducteur (4, 4') reliée à la bobine (2) et une seconde portion de conducteur (6, 6') non reliée à la bobine (2) et couplée de manière capacitive à ladite première portion de conducteur (4, 4').

10. Circuit d'alimentation selon l'une quelconque des revendications 1 à 9, **caractérisé en ce que** les portions de ligne multiconducteur (3, 3') consistent en des portions de ligne triaxiale ou à trois conducteurs concentriques (4, 6, 13 ; 4', 6', 13'), au moins le premier circuit oscillant (5) intégrant les portions de conducteur (4, 4') reliées directement à la bobine (2) desdites lignes triaxiales (3, 3') et ledit au moins un circuit oscillant supplémentaire (9) intégrant les portions de conducteur concentriques supplémentaires non reliées (6, 6') desdites lignes triaxiales (3, 3'), un transfert d'énergie s'effectuant entre ces conducteurs concentriques respectivement associés, du fait de la capacité linéique répartie desdites lignes triaxiales (3, 3').

11. Circuit d'alimentation selon la revendication 10, **caractérisé en ce que** les portions de conducteur (4, 4') reliées directement à la bobine (2) des lignes triaxiales (3, 3') sont constitués par les conducteurs intermédiaires de ces dernières et **en ce que** ledit au moins un circuit oscillant supplémentaire (9) comprend les portions de conducteur central (6, 6') non reliées à la bobine (2), la capacité linéique répartie entre les conducteurs centraux et intermédiaires fournissant une connexion par couplage permettant audit au moins un circuit oscillant supplémentaire considéré (9) de se boucler sur la bobine (2) par l'intermédiaire desdits conducteurs intermédiaires (4, 4') reliés à celle-ci.

12. Circuit d'alimentation selon la revendication 11, **caractérisé en ce que** les portions de conducteur intermédiaire (4, 4') présentent chacun une coupure ou discontinuité physique (15, 15') au niveau d'un point froid non interférent respectif et **en ce que** les portions de lignes additionnelles (8, 8') dudit au moins un autre circuit oscillant supplémentaire (10) sont reliées au niveau desdits points froids auxdites portions de conducteur intermédiaires (4, 4') reliées à la bobine (2), les deux parties desdites portions de conducteur intermédiaires (4, 4') mutuellement en regard au niveau de ladite coupure ou discontinuité (15, 15') étant reliées entre elles par des circuits de transfert d'énergie (16, 16') sélectifs en fréquence, par exemple des filtres passe-bande centrés sur la fréquence de résonance du premier circuit oscillant (5) et transmettant le maximum d'énergie pour cette fréquence.

13. Circuit d'alimentation selon la revendication 10, **caractérisé en ce que** les portions de conducteur (4, 4') reliées directement à la bobine (2) des lignes triaxiales sont constitués par les portions de conducteur central de ces dernières et **en ce que** ledit au moins un circuit oscillant supplémentaire (9) intègre les portions de conducteur intermédiaire (6, 6') non reliées à la bobine (2), la capacité linéique répartie entre ces conducteurs centraux et intermédiaires fournissant une connexion par couplage permettant audit au moins un circuit oscillant supplémentaire (9) considéré de se boucler sur la bobine (2) par l'intermédiaire des conducteurs centraux (4, 4') reliés à celle-ci.

14. Circuit d'alimentation selon la revendication 13, **caractérisé en ce que** les conducteurs des portions de lignes additionnelles (8, 8') dudit au moins un autre circuit oscillant supplémentaire (10) sont reliés aux conducteurs centraux (4, 4') au niveau de points froids non interférents (14, 14') de ces conducteurs, **en ce que** des filtres réjecteurs (17, 17') isolent entre eux le premier circuit oscillant (5) et le ou les autre(s) circuit(s) oscillant(s) supplémentaire(s) (10) dont les portions de lignes additionnelles (8, 8') sont reliées auxdits conducteurs centraux et **en ce que** ces derniers circuits oscillants (5, 10) sont également isolés dudit au moins un circuit oscillant supplémentaire (9) intégrant les conducteurs intermédiaires non reliés à la bobine, par des filtres réjecteurs adaptés (18, 18' ; 19, 19').

15. Circuit d'alimentation selon l'une quelconque des revendications 1 à 14, **caractérisé en ce que** le circuit d'alimentation primaire (12, 12', 12") de l'un au moins des circuits oscillants (5, 9, 10) est partiellement confondu avec ce circuit oscillant en intégrant une partie de circuit commune (20) avec ce circuit oscillant, et **en ce que** ledit circuit d'alimentation primaire (12, 12', 12") comprend, d'une part, un générateur radiofréquence (21) ajusté à la fréquence de résonance déterminée du circuit oscillant associé (5, 9, 10) et relié audit circuit oscillant au niveau d'une borne du circuit ou composant d'accord symétrique réglable correspondant (11, 11', 11") par l'intermédiaire d'une capacité de couplage (22) et, d'autre part, un circuit ou composant d'adaptation (23) relié à l'autre borne dudit circuit ou composant d'accord symétrique réglable, le composant d'adaptation (23) et le composant d'accord symétrique réglable (11, 11', 11") faisant partie des deux circuits (12, 12', 12" et 5, 9, 10), consistant en des capacités et le générateur (21) pouvant fonctionner de manière continue, par intermittence ou pulsée.

16. Circuit d'alimentation selon l'une quelconque des revendications 1 à 14, **caractérisé en ce que** le circuit d'alimentation primaire (12, 12', 12") de l'un au moins des circuits oscillants (5, 9, 10) consiste en un circuit séparé et comprend, en plus d'un générateur radiofréquence (21) ajusté à la fréquence de résonance déterminée du circuit oscillant concerné et du ou des éléments participant au couplage avec l'un au moins des deux portions de conducteur (4, 4') reliée à la bobine (2) d'une ou des portions de ligne principales (3, 3') et au circuit ou composant d'accord (11, 11', 11"), également un circuit ou composant d'adaptation (23) destiné à optimiser le couplage et à en limiter certains effets au niveau dudit circuit d'alimentation primaire.

17. Circuit d'alimentation selon la revendication 16, **caractérisé en ce que** le ou chaque couplage [circuit d'alimentation primaire (12, 12', 12") / circuit oscillant correspondant (5, 9, 10) concerné] est un couplage essentiellement de nature magnétique et **en ce que** le circuit ou composant d'adaptation (23) est une capacité réglable destinée à annuler la réactance inductive au niveau du circuit d'alimentation primaire considéré.

18. Circuit d'alimentation selon l'une quelconque des revendications 16 et 17, **caractérisé en ce que** le transfert d'énergie par couplage entre un circuit d'alimentation primaire (12, 12', 12") et le circuit oscillant associé (5, 9, 10) consiste en un couplage double et affecte de manière symétrique et équivalente les portions de conducteur (4, 4' ; 6, 6') similaires des deux portions de ligne de transmission (3, 3' ; 8, 8' ; 7, 7') concernées.

19. Circuit d'alimentation selon l'une quelconque des revendications 17 et 18, **caractérisé en ce que** le ou chacun des deux couplage(s) [circuit d'alimentation primaire (12, 12', 12") / circuit oscillant correspondant concerné (5, 9, 10)] réalisant le transfert d'énergie entre ces deux circuits consiste en un couplage principalement magnétique entre, d'une part, un segment (24, 24', 24") d'une portion de conducteur d'une des portions de ligne (3, 3' ; 7, 7' ; 8, 8') du circuit oscillant considéré (5, 9, 10) et, d'autre part, un segment en regard (25, 25', 25") de la ligne reliant le générateur (21) au composant d'adaptation (23) dans le circuit d'alimentation primaire (12, 12', 12") associé, les deux segments de chacune de ces paires de segments mutuellement associés (24, 25 ; 24', 25' ; 24", 25") présentant des longueurs déterminées et étant disposés parallèlement et à proximité l'un de l'autre de manière à former des lignes de Lecher.

20. Circuit d'alimentation selon l'une quelconque des revendications 17 et 18, **caractérisé en ce que** le ou chaque couplage à transfert d'énergie [circuit d'alimentation primaire (12, 12', 12") / circuit oscillant correspondant concerné (5, 9, 10)] consiste en un couplage magnéto-capacitif, symétrique ou asymétrique, entre, d'une part, un solénoïde (26) monté en série dans ledit circuit d'alimentation primaire (12, 12', 12") et, d'autre part, un ensemble capacité/inductance(s) monté en série dans le circuit oscillant (5, 9, 10) concerné associé, ladite capacité pouvant correspondre au composant d'accord (11, 11', 11") et les inductances (27 et 27') comprendre deux inductances équivalentes montées en série de part et d'autre de ladite capacité d'accord, en faisant éventuellement partie chacune d'un circuit LC.

21. Circuit d'alimentation selon l'une quelconque des revendications 1 à 20, **caractérisé en ce que** le premier circuit oscillant (5) et/ou ledit au moins un circuit oscillant supplémentaire (9, 10) intègrent un ou des filtres d'isolation réjecteurs de bande (17, 17' ; 18, 18' ; 19, 19') ajustés, le cas échéant chacun, sur la fréquence de résonance de l'autre ou de l'un des autres circuits oscillant(s).

22. Circuit d'isolation selon la revendication 21, **caractérisé en ce que** les filtres d'isolation se présentent sous la forme de paire(s) de filtres disposées symétriquement dans le circuit oscillant concerné, chaque filtre d'une paire donnée de filtres étant relié en série à ou monté en série avec l'une des portions de conducteur faisant partie dudit circuit oscillant concerné.

23. Circuit d'alimentation selon la revendication 21 ou 22, **caractérisé en ce que,** en présence d'un premier circuit oscillant (5) et de deux circuits oscillants supplémentaires (9 et 10), au moins l'un (10) desdits circuits oscillants intègre deux paires de filtres d'isolation (17, 17' ; 18, 18' ; 19, 19'), chaque paire de filtres étant ajustée sur la fréquence de résonance de l'un des deux autres circuits oscillants (5 et 9), l'une (19, 19') des paires de filtres au moins étant réglable en fréquence, préférentiellement de manière continue.

24. Circuit d'alimentation selon l'une quelconque des revendications 16 et 17, **caractérisé en ce que** les filtres d'isolation consistent en des paires de circuits LC, la ou les paire(s) de filtres (19, 19') éventuellement réglable(s) en fréquence intégrant des capacités variables (28, 28') de manière continue avec un asservissement mécanique mutuel de leur réglage (29).

25. Sonde RMN multifréquence, **caractérisée en ce qu'**elle est pourvue d'un circuit d'alimentation (1) de la bobine d'échantillon (2) selon l'une quelconque des revendications 1 à 24.

26. Spectromètre RMN, en particulier pour spectrométrie en phase solide, **caractérisé en ce qu'**il comprend un circuit d'alimentation (1) de la bobine d'échantillon (2) selon l'une quelconque des revendications 1 à 24.

## Claims

1. Multi-frequency power supply circuit for a coil, in particular an NMR coil or a sample coil, comprising two main power supply or transmission line portions each including at least one conductor portion connected to one of the ends or terminals of said coil, these connected conductor portions constituting with said coil an oscillatory circuit or first oscillatory circuit having a particular resonant frequency, which circuit (1) is **characterised in that** the main power supply or transmission line portions (3, 3') consist of controlled impedance multiconductor line portions each including at least one other conductor portion (6, 6') not connected to the coil (2), extending in said main line portion (3, 3') alongside the corresponding respective connected conductor portion (4, 4') and capacitively coupled to the latter in a distributed manner along the segments situated alongside or facing said conductors (4, 4' and 6, 6'), **in that** said non-connected conductor portions (6, 6') form, with the coil (2) and the connected conductor portions (4, 4') and non-connected conductor portions (6, 6'), and where applicable with additional power supply line portions (7, 7'; 8, 8') connected to said non-connected conductor portions (6, 6'), at least one supplementary oscillatory circuit (9, 10) having a resonant frequency different from that of the first oscillatory circuit (5), and **in that** each of said oscillatory circuits (5, 9, 10) is looped to a respective variable tuning component or circuit (11, 11', 11") and is supplied with power by a respective corresponding primary power supply circuit (12, 12', 12") by transferring energy by magnetic, capacitive or magnetocapacitive coupling of the primary power supply circuit (12, 12', 12") concerned with, respectively, at least one of the two connected conductor portions (4, 9'), at least one of the two non-connected conductor portions (6, 6') or at least one of the additional line portions (7, 7'; 8, 8') forming part of the supplementary oscillatory circuit (9, 10) concerned.

2. Power supply circuit according to claim 1, **characterised in that** each oscillatory circuit (5, 9, 10) has a symmetrical structure and a symmetrical composition integrating connected conductor portions (4, 9'), where applicable non-connected conductor portions (6, 6'), and additional line portions (7, 7'; 8, 8'), respectively of identical types and lengths in pairs, the two connected conductor portions (4, 4') forming part of the first oscillatory circuit (5) having a length that is a multiple of half the resonant wavelength of said first oscillatory circuit (5).

3. Power supply circuit according to either of claims 1 and 2, **characterised in that** the supplementary oscillatory circuit(s) (9, 10) has/have a resonant frequency or resonant frequencies higher than that of the first oscillatory circuit (5), the length of the respective mutually facing segments of the connected conductor portions (4, 4') and the non-connected conductor portions (6, 6') of two main line portions (3, 3') being sufficient for the degree or level of coupling resulting from the capacitance per unit length distributed along said line portions to transfer sufficient energy for the resonant frequency or frequencies of said supplementary oscillatory circuit(s) (9, 10).

4. Power supply circuit according to any one of claims 1 to 3, **characterised in that** the two main power supply or transmission line portions (3 and 3') include at least one isolating coating or conductor (13) forming a shield around the connected conductor portions and the non-connected conductor portions, between the latter and the outside.

5. Power supply circuit according to any one of claims 1 to 4, **characterised in that** the conductors (4, 4'; 6, 6') of the main power supply or transmission line portions (3, 3') consist of ribbon conductors assembled with interpolated dielectric material into lines with a stratified or sandwich structure, preferably of flexible composition, the additional power supply line portions (7, 7'; 8, 8') preferably consisting of coaxial lines.

6. Power supply circuit according to any one of claims 1 to 4, **characterised in that** the conductors (4, 4'; 6, 6') of the main power supply or transmission line portions (3, 3') consist of concentric and coaxial conductors with a central wire conductor and with one or more concentric tubular conductors around that wire conductor and with interpolated dielectric layers, the additional power supply line portions (7, 7'; 8, 8') preferably consisting of coaxial lines.

7. Power supply circuit according to any one of claims 1 to 6, **characterised in that** it comprises, in addition to the first oscillatory circuit (5) and a first supplementary oscillatory circuit (9), at least one other supplementary oscillatory circuit (10) of symmetrical structure with a resonant frequency different from those of the aforementioned oscillatory circuits (5 and 9) and consisting of the NMR coil (2), parts of the connected conductor portions (4, 4') of the main line portions (3, 3') and additional transmission line portions (8, 8') specific to said other oscillatory circuit(s) (10), **in that** these two [specific line portion (8, 8')/consecutive connected conductor portion part (4, 4')] assemblies have identical cumulative lengths equal to a multiple of half the resonant wavelength of the other circuit(s) (10), and **in that** these specific line portions (8, 8') are looped to a variable tuning circuit or component (11") with a symmetrical structure at one of their ends and are each connected at their other end to one of the connected conductor portions (4, 4') of the main line portions (3, 3') at a non-interfering cold point (14 or 14') of the connected conductor portion (4 or 4') concerned.

8. Power supply circuit according to any one of claims 1 to 6, **characterised in that** it comprises, in addition to the first oscillatory circuit (5) and a first supplementary oscillatory circuit (9), at least one other supplementary oscillatory circuit (10) of symmetrical structure with a resonant frequency different from those of the aforementioned oscillatory circuits (5 and 9), and **in that** the other oscillatory circuit(s) (10) primarily consist(s) of transmission line portions (8, 8') specific to said other circuit (10), looped to a symmetrical structure variable tuning circuit or component (11') at one of the ends of each of said specific line portions (8, 8') and each connected by their other end to one of the non-connected conductor portions (6, 6') of the main transmission or power supply line portions (3, 3').

9. Power supply circuit according to any one of claims 1 to 8, **characterised in that** the multiconductor line portions (3, 3') constituting the main power supply or transmission line portions each comprise, in addition to the or a shielding coating or conductor (13), a first conductor portion (4, 4') connected to the coil (2) and a second conductor portion (6, 6') not connected to the coil (2) and capacitively coupled to said first conductor portion (4, 4').

10. Power supply circuit according to any one of claims 1 to 9, **characterised in that** the multiconductor line portions (3, 3') consist of triaxial line portions or portions of lines with three concentric conductors (4, 6, 13; 4', 6', 13'), at least the first oscillatory circuit (5) integrating conductor portions (4, 4') connected directly to the coil (2) of said triaxial lines (3, 3') and said at least one supplementary oscillatory circuit (9) integrating the non-connected supplementary concentric conductor portions (6, 6') of said triaxial lines (3, 3'), energy being transferred between these respectively associated concentric conductors by virtue of the distributed capacitance per unit length of said triaxial lines (3, 3').

11. Power supply circuit according to claim 10, **characterised in that** the conductor portions (4, 4') of the triaxial lines (3, 3') connected directly to the coil (2) consist of the intermediate conductors of the triaxial lines and **in that** said at least one supplementary oscillatory circuit (9) comprises the central conductor portions (6, 6') not connected to the coil (2), the distributed capacitance per unit length between the central and intermediate conductors providing a coupling enabling said at least one supplementary oscillatory circuit (9) concerned to be looped to the coil (2) via said intermediate conductors (4, 4') connected thereto.

12. Power supply circuit according to claim 11, **characterised in that** the intermediate conductor portions (4, 4') each have a break or physical discontinuity (15, 15') at a respective non-interfering cold point and **in that** the additional line portions (8, 8') of said at least one other supplementary oscillatory circuit (10) are connected at said cold points to said intermediate conductor portions (4, 4') connected to the coil (2), the two parts of said intermediate conductor portions (4, 4') facing each other at said break or discontinuity (15, 15') being interconnected by frequency-selective energy transfer circuits (16, 16'), for example band-pass filters centred on the resonant frequency of the first oscillatory circuit (5) and transmitting the maximum energy for that frequency.

13. Power supply circuit according to claim 10, **characterised in that** the conductor portions (4, 4') of the triaxial lines connected directly to the coil (2) consist of the central conductor portions of the triaxial lines and **in that** said at least one supplementary oscillatory circuit (9) integrates the intermediate conductor portions (6, 6') not connected to the coil (2), the distributed capacitance per unit length between these central and intermediate conductors providing coupling enabling said at least one supplementary oscillatory circuit (9) concerned to be looped to the coil (2) via central conductors (4, 4') connected to it.

14. Power supply circuit according to claim 13, **characterised in that** the conductors of the additional line portions (8, 8') of said at least one other supplementary oscillatory circuit (10) are connected to the central conductors (4, 4') at the non-interfering cold points (14, 14') of those conductors, **in that** stop filters (17, 17') isolate from each other the first oscillatory circuit (5) and the other supplementary oscillatory circuit(s) (10) the additional line portions (8, 8') whereof are connected to said central conductors, and **in that** the latter oscillatory circuits (5, 10) are also isolated from said at least one supplementary oscillatory circuit (9) integrating the intermediate conductors not connected to the coil by tuned stop filters (18, 18'; 19, 19').

15. Power supply circuit according to any one of claims 1 to 14, **characterised in that** the primary power supply circuit (12, 12' 12") of at least one of the oscillatory circuits (5, 9, 10) is partially combined with that oscillatory circuit by integrating a circuit portion (20) common to that oscillatory circuit, and **in that** said primary power supply circuit (12, 12', 12") comprises, on the one hand, a radio-frequency generator (21) tuned to the particular resonant frequency of the associated oscillatory circuit (5, 9, 10) and connected to said oscillatory circuit at a terminal of the corresponding adjustable symmetrical tuning circuit or component (11, 11', 11") by way of a coupling capacitor (22) and, on the other hand, a matching circuit or component (23) connected to the other terminal of said adjustable symmetrical tuning circuit or component, the matching component (23) and the adjustable symmetrical tuning component (11, 11', 11") being part of the two circuits (12, 12', 12" and 5, 9, 10) consisting of capacitors and the generator (21) being able to operate continuously, intermittently or in pulsed mode.

16. Power supply circuit according to any one of claims 1 to 14, **characterised in that** the primary power supply circuit (12, 12' 12") of at least one of the oscillatory circuits (5, 9, 10) consists of a separate circuit and comprises, in addition to a radio-frequency generator (21) tuned to the particular resonant frequency of the oscillatory circuit concerned and the component(s) contributing to the coupling with at least one of the two conductor portions (4, 4') connected to the coil (2) of one or more main line portions (3, 3') and to the tuning circuit or component (11, 11', 11"), a matching circuit or component (23) adapted to optimise the coupling and to limit certain effects thereof on said primary power supply circuit.

17. Power supply circuit according to claim 16, **characterised in that** the or each [primary power supply circuit (12, 12' 12")/corresponding oscillatory circuit (5, 9, 10) concerned] coupling is an essentially magnetic coupling and **in that** the matching circuit or component (23) is a variable capacitor for cancelling the inductive reactance in the primary power supply circuit concerned.

18. Power supply circuit according to either of claims 16 and 17, **characterised in that** the energy transfer coupling between a primary power supply circuit (12, 12' 12") and the associated oscillatory circuit (5, 9, 10) is a double coupling and affects the similar conductor portions (4, 4'; 6, 6') of the two transmission line portions (3, 3'; 8, 8'; 7, 7') concerned symmetrically and in an equivalent manner.

19. Power supply circuit according to either of claims 17 and 18, **characterised in that** the or each of the two [primary power supply circuit (12, 12' 12")/corresponding oscillatory circuit (5, 9, 10) concerned] coupling(s) transferring energy between these two circuits is a mainly magnetic coupling between, on the one hand, a segment (24, 24', 24") of a conductor portion of one of the line portions (3, 3'; 7, 7'; 8, 8') of the oscillatory circuit concerned (5, 9, 10) and, on the other hand, a facing segment (25, 25', 25") of the line connecting the generator (21) to the matching component (23) in the associated primary power supply circuit (12, 12', 12"), the two segments of each of these pairs of mutually associated segments (24, 25; 24', 25'; 24", 25") having particular lengths and being disposed parallel to and close to each other to form Lecher lines.

20. Power supply circuit according to either of claims 17 and 18, **characterised in that** the or each [primary power supply circuit (12, 12' 12") /corresponding oscillatory circuit (5, 9, 10) concerned] energy transfer coupling is a symmetrical or asymmetrical magneto-capacitive coupling between, on the one hand, a solenoid (26) connected in series in said primary power supply circuit (12, 12', 12") and, on the other hand, a capacitor/inductor system connected in series in the associated oscillatory circuit (5, 9, 10) concerned, where said capacitor can correspond to the tuning component (11, 11', 11") and the inductors (27 and 27') comprising two equivalent inductors connected in series on respective opposite sides of said tuning capacitor, where applicable each forming part of an LC circuit.

21. Power supply circuit according to any one of claims 1 to 20, **characterised in that** the first oscillatory circuit (5) and/or said at least one supplementary oscillatory circuit (9, 10) integrate(s) one or more tuned band-stop isolating filters (17, 17'; 18, 18'; 19, 19') each tuned, where applicable, to the resonant frequency of the other oscillatory circuit or one of the other oscillatory circuits.

22. Isolating circuit according to claim 21, **characterised in that** the isolating filters take the form of pairs of filters disposed symmetrically in the oscillatory circuit concerned, each filter of a given pair of filters being connected in series to or connected in series with one of the conductor portions forming part of said oscillatory circuit concerned.

23. Power supply circuit according to claim 21 or claim 22, **characterised in that,** in the presence of a first oscillatory circuit (5) and two supplementary oscillatory circuits (9 and 10), at least one (10) of said oscillatory circuits integrates two pairs of isolating filters (17, 17'; 18, 18'; 19, 19'), each pair of filters being tuned to the resonant frequency of one of the two other oscillatory circuits (5 and 9), and at least one of the filter pairs (19, 19') being tunable, preferably continuously.

24. Power supply circuit according to either of claims 16 and 17, **characterised in that** the isolating filters consist of pairs of LC circuits, the filter pair(s) (19, 19'), where applicable of variable frequency, integrating continuously variable capacitors (28, 28') with mutual mechanical control of their setting (29).

25. Multifrequency NMR probe **characterised in that** it is provided with a power supply circuit (1) according to any one of claims 1 to 24 for the sample coil (2).

26. NMR spectrometer, in particular for solid phase spectrometry, **characterised in that** it includes a power supply circuit (1) according to any one of claims 1 to 24 for the sample coil (2).

## Patentansprüche

1. Multifrequenz-Einspeisestromkreis einer Spule, insbesondere einer NMR-Spule oder Probenspule, die zwei Abschnitte einer Einspeise- oder Übertragungsleitung, sog. Leitungshauptabschnitte umfasst, wobei diese Leitungshauptabschnitte jeweils mindestens einen Leiterabschnitt, der mit einem der Enden oder Klemmen der Spule verbunden ist, umfassen, wobei diese verbundenen Leiterabschnitte mit der Spule einen Schwingkreis oder einen ersten Schwingkreis mit einer bestimmten Resonanzfrequenz bilden, wobei der Stromkreis (1) **dadurch gekennzeichnet ist, dass** die Hauptabschnitte der Einspeise- oder Übertragungsleitungen (3, 3') aus mehrsträngigen Leitungsabschnitten steuerbarer Impedanz bestehen, die jeweils mindestens einen anderen mit der Spule (2) nicht verbundenen Leiterabschnitt (6, 6') aufweisen, der sich in dem Leitungshauptabschnitt (3, 3') neben dem verbundenen bzw. entsprechenden Leiterabschnitt (4, 4') zusammengehörig erstreckt und mit diesem letzteren eine kapazitive Kopplung aufweist, die entlang der gegenüber liegenden Segmente oder bezüglich der Leiter (4, 4' und 6, 6') verteilt ist, und **dadurch** dass die nicht verbundenen Leiterabschnitte (6, 6'), zusammen mit der Spule (2) und den verbundenen Leiterabschnitten (4, 4') und nicht verbundenen Leiterabschnitten (6, 6') und gegebenenfalls mit zusätzlichen Abschnitten einer Einspeiseleitung (7, 7' ; 8, 8'), die an die nicht verbundenen Leiterabschnitte (6, 6') angeschlossen sind, mindestens einen zusätzlichen Schwingkreis (9, 10) bilden, der eine Resonanzfrequenz besitzt, die sich von derjenigen des ersten Schwingkreises (5) unterscheidet, und dass jeder der Schwingkreise (5, 9, 10) durch einen Stromkreis oder eine jeweils regelbare Abgleichkomponente (11, 11', 11") zu einer Schleife geschaltet ist, und mittels eines jeweils zugehörigen primären Speisestromkreises (12, 12', 12") anhand eines Energietransfers durch magnetische, kapazitive oder magneto-kapazitive Kopplung des betroffenen primären Speisestromkreises (12, 12', 12") mit jeweils mindestens dem einen der beiden verbundenen Leiterabschnitte (4, 4'), mindestens dem einen der beiden nicht verbundenen Leiterabschnitte (6, 6') oder auch mindestens dem einen der zusätzlichen Leitungsabschnitte (7, 7' ; 8, 8'), die Teil des betroffenen zusätzlichen Schwingkreises (9, 10) sind, gespeist wird.

2. Einspeisestromkreis nach Anspruch 1, **dadurch gekennzeichnet, dass** jeder Schwingkreis (5, 9, 10) eine symmetrische Struktur und einen symmetrischen Aufbau aufweist, die verbundene Leiterabschnitte (4, 4') und gegebenenfalls nicht verbundene Leiterabschnitte (6, 6') sowie zusätzliche Leitungsabschnitte (7, 7' ; 8, 8'), die jeweils paarweise identischen Typs und von identischer Länge sind, integriert, wobei die beiden verbundenen Leiterabschnitte (4, 4'), die Teil des ersten Schwingkreises (5) sind, eine vielfache Länge der Resonanz-Halbwellenlänge des ersten Schwingkreises (5) aufweist.

3. Einspeisestromkreis nach einem der Ansprüche 1 und 2, **dadurch gekennzeichnet, dass** der oder die zusätzliche(n) Swingkreis(e) (9, 10) eine höhere oder höhere Resonanzfrequenz(en) aufweisen als diejenige des ersten Schwingkreises (5), wobei die Länge der jeweils gegenüberliegenden Segmente der verbundenen (4, 4') und nicht verbundenen (6, 6') Leiterabschnitte der beiden Leitungshauptabschnitte (3, 3') ausreichend sind, damit der Grad oder das Niveau der Kopplung, der/die aus der entlang dieser Leiterabschnitte verteilten längenbezogenen Kapazität resultiert, einen ausreichenden Energietransfer für die Resonanzfrequenz(en) des oder der zusätzlichen Schwingkreise(s) (9, 10) gewährleistet.

4. Einspeisestromkreis nach einem der Ansprüche 1 bis 3, **dadurch gekennzeichnet, dass** die beiden Hauptabschnitte der Einspeise- oder Übertragungsleitung (3, 3') mindestens eine Umhüllung oder einen Leiter (13) aufweisen, der eine Abschirmung um die verbundenen oder nicht verbundenen Leiterabschnitte zwischen letzteren und der Umgebung bildet.

5. Einspeisestromkreis nach einem der Ansprüche 1 bis 4, **dadurch gekennzeichnet, dass** die Leiter (4, 4' ; 6, 6') der Hauptabschnitte der Einspeise- oder Übertragungsleitung (3, 3') aus zusammengefügten Bandleitern, mit dazwischen gestelltem dielektrischem Material, aus Leitungen mit geschichteter oder sandwichförmiger Struktur, mit vorzugsweise flexiblem Aufbau bestehen, wobei die zusätzlichen Abschnitte der Einspeiseleitung (7, 7' ; 8, 8') vorzugsweise aus koaxialen Leitungen bestehen.

6. Einspeisestromkreis nach einem der Ansprüche 1 bis 4, **dadurch gekennzeichnet, dass** die Leiter (4, 4' ; 6, 6') der Hauptabschnitte der Einspeise- oder Übertragungsleitung (3, 3') aus konzentrischen und koaxialen Leitern mit einem zentralen faserförmigen Leiter und einem oder mehreren rohrförmigen Leitern, die diesen faserförmigen Leiter konzentrisch umgeben, mit einer Dazwischenstellung von dielektrischen Schichten, wobei die zusätzlichen Abschnitte der Einspeiseleitung (7, 7' ; 8, 8') vorzugsweise aus koaxialen Leitungen bestehen, bestehen.

7. Einspeisestromkreis nach einem der Ansprüche 1 bis 6, **dadurch gekennzeichnet, dass** er zusätzlich zu dem ersten Schwingkreis (5) und einem zusätzlichen ersten Schwingkreis (9) mindestens einen anderen zusätzlichen Schwingkreis (10) mit symmetrischer Struktur aufweist, der eine Resonanzfrequenz besitzt, die sich von derjenigen der oben genannten Schwingkreise (5 und 9) unterscheidet und durch die NMR-Spule (2), durch Teile der verbundenen Leiterabschnitte (4, 4') der Leitungshauptabschnitte (3, 3') und durch zusätzliche Abschnitte der Übertragungsleitung (8, 8'), die den/dem anderen Schwingkreis(en) (10) eigen ist, gebildet ist, und dass diese beiden Anordnungen [(spezieller Leitungsabschnitt (8, 8') / nachfolgender Teil des verbundenen Leiterabschnitts (4, 4')] kumulierte Längen aufweisen, die identisch und gleich einem Vielfachen der Resonanz-Halbwellenlänge dieses/dieser anderen Stromkreises/Stromkreise (10) sind, und dass diese speziellen Leitungsabschnitte (8, 8') durch einen Stromkreis oder eine regelbare Abgleichkomponente (11") mit symmetrischer Struktur auf dem Niveau einer ihrer Enden zur Schleife geschaltet sind und durch ihre anderen Enden jeweils mit einem der verbundenen Leiterabschnitte (4, 4') der Leitungshauptabschnitte (3, 3') auf dem Niveau eines kalten nicht interferierenden Punktes (14 oder 14') des betreffenden verbundenen Leiterabschnitts (4 oder 4') angeschlossen sind.

8. Einspeisestromkreis nach einem der Ansprüche 1 bis 6, **dadurch gekennzeichnet, dass** er zusätzlich zu dem ersten Schwingkreis (5) und einem zusätzlichen ersten Schwingkreis (9) mindestens einen anderen zusätzlichen Schwingkreis (10) mit symmetrischer Struktur aufweist, der eine Resonanzfrequenz besitzt, die sich von derjenigen der oben genannten Schwingkreise (5 und 9) unterscheidet, und dass dieser oder diese andere(n) Schwingkreis(e) (10) im Wesentlichen gebildet ist/sind durch Abschnitte der Übertragungsleitung (8, 8'), die diesem Stromkreis (10) eigen sind, die durch einen Stromkreis oder eine regelbare Abgleichkomponente (11") mit symmetrischer Struktur auf dem Niveau einer ihrer Enden der eigenen, verbundenen Leitungsabschnitte (8, 8') zu einer Schleife geschaltet sind und durch ihr anderes Ende jeweils mit einem der nicht verbundenen Leiterabschnitte (6, 6') der Hauptabschnitte (3, 3') der Übertragungsleitung oder Einspeisungsleitung angeschlossen sind.

9. Einspeisestromkreis nach einem der Ansprüche 1 bis 8, **dadurch gekennzeichnet, dass** die Abschnitte der Leitung mit mehreren Strängen (3, 3') die die Hauptabschnitte der Leitung zur Einspeisung oder Übertragung bilden, außerdem jeweils, zusätzlich zu der oder einer Umhüllung oder Leiterabschirmung (13), einen ersten Leiterabschnitt (4, 4'), der mit der Spule (2) verbunden ist und einen zweiten Leiterabschnitt (6, 6'), der nicht mit der Spule (2) verbunden ist und kapazitiv mit dem ersten Leiterabschnitt (4, 4') gekoppelt ist, umfassen.

10. Einspeisestromkreis nach einem der Ansprüche 1 bis 9, **dadurch gekennzeichnet, dass** die Abschnitte der Leitung mit mehreren Strängen (3, 3') aus Leistungsabschnitten aus Triaxialkabel oder aus drei konzentrischen Leitern (4, 6, 13 ; 4', 6', 13') bestehen, wobei wenigstens der erste Schwingkreis (5), der die Leiterabschnitte (4, 4'), die direkt mit der Spule (2) der triaxialen Leitungen (3, 3') verbunden sind, integriert und wobei wenigstens ein zusätzlicher Schwingkreis (9), die nicht verbundenen, zusätzlichen, konzentrischen Leiterabschnitte (6, 6') der triaxialen Leiter (3, 3') integriert, wobei ein Energietransfer zwischen diesen jeweils miteinander verbundenen, konzentrischen Leitern, aufgrund der verteilten längenbezogenen Kapazität der triaxialen Leiter (3, 3') erfolgt.

11. Einspeisestromkreis nach Anspruch 10, **dadurch gekennzeichnet, dass** die Leiterabschnitte (4, 4'), die direkt mit der Spule (2) der triaxialen Leiter (3, 3') verbunden sind, durch die Zwischenleiter von letzteren gebildet sind, und dass der mindestens eine zusätzliche Schwingkreis (9) die Abschnitte des zentralen Leiters (6, 6'), die nicht mit der Spule (2) verbunden sind, umfasst, wobei die Kapazität, die längenmäßig zwischen den zentralen Leitern und den Zwischenleitern verteilt ist, eine Kopplungsverbindung bereitstellt, die es mindestens einem betreffenden zusätzlichen Schwingkreis (9) ermöglicht, sich mit der Spule (2) mittels der mit dieser verbundenen Zwischenleiter (4, 4') zur Schleife zu schalten.

12. Einspeisestromkreis nach Anspruch 11, **dadurch gekennzeichnet, dass** die Abschnitte des Zwischenleiters (4, 4') jeweils eine physikalische Unterbrechung oder Diskontinuität (15, 15') auf dem Niveau eines jeweils nicht interferierenden, kalten Punktes aufweisen, und dass die zusätzlichen Leiterabschnitte (8, 8') des mindestens einen anderen zusätzlichen Stromkreises (10) auf dem Niveau der kalten Punkte mit den mit der Spule (2) verbundenen Abschnitten des Zwischenleiters (4, 4') verbunden sind, wobei die beiden Teile der Zwischenleiterabschnitte (4, 4') gegenseitig untereinander gegenüber auf dem Niveau der Unterbrechung oder der Diskontinuität (15, 15') durch Energietransferstromkreise (16, 16') verbunden sind, die hinsichtlich der Frequenz selektiv sind, beispielsweise Bandfilter, die auf die Resonanzfrequenz des ersten Schwingkreises (5) getrimmt sind und das Maximum an Energie für diese Frequenz übertragen.

13. Einspeisestromkreis nach Anspruch 10, **dadurch gekennzeichnet, dass** die Leiterabschnitte (4, 4'), die direkt mit der Spule (2) der triaxialen Leitungen verbunden sind, durch die Abschnitte des zentralen Leiters von letzteren gebildet sind, und dass der mindestens eine zusätzliche Schwingkreis (9) die nicht mit der Spule (2) verbundenen Abschnitte des Zwischenleiters (6, 6') integriert, wobei die linienförmige, zwischen diesen zentralen Leitern und Zwischenleitern verteilte Kapazität eine Kopplungsverbindung bereitstellt, die es diesem mindestens einen betreffenden zusätzlichen Schwingkreis (9) ermöglicht, sich mit der Spule (2) mittels der mit dieser verbundenen, zentralen Leiter (4, 4') zu einer Schleife zu schalten.

14. Einspeisestromkreis nach Anspruch 13, **dadurch gekennzeichnet, dass** die Leiter der zusätzlichen Leitungsabschnitte (8, 8') des mindestens einen anderen zusätzlichen Schwingkreises (10) mit den zentralen Leitern (4, 4') auf dem Niveau von nicht interferierenden, kalten Punkten (14, 14') dieser Leiter verbunden sind, dass Sperrfilter (17, 17') untereinander den ersten Schwingkreis (5) und den oder die anderen zusätzlichen Schwingkreis(e) (10), deren zusätzliche Leiterabschnitte (8, 8') mit den zentralen Leitern verbunden sind, isolieren, und dass diese letzteren Schwingkreise (5, 10) auch von diesem mindestens einen zusätzlichen Schwingkreis (9), der die nicht mit der Spule verbundenen Zwischenleiter integriert, durch angepasste Sperrfilter (18, 18' ; 19, 19'), isoliert sind.

15. Einspeisestromkreis nach einem der Ansprüche 1 bis 14, **dadurch gekennzeichnet, dass** der primäre Einspeisestromkreis (12, 12', 12") des mindestens einen der Schwingkreise (5, 9, 10) teilweise mit diesem Schwingkreis zusammenläuft, indem ein Teil des gemeinsamen Stromkreises (20) in diesen Schwingkreis integriert wird, und dass der primäre Einspeisestromkreis (12, 12', 12") einerseits einen Hochfrequenz-Generator (21) beinhaltet, der an die bestimmte Resonanzfrequenz des Schwingkreises (5, 9, 10) angepasst und mit diesem Schwingkreis auf dem Niveau einer Klemme des Stromkreises oder einer entsprechenden regelbaren, symmetrischen Abgleichkomponente (11, 11', 11") mittels einer koppelnden Kapazität (22) verbunden ist, und andererseits einen Anpassungsstromkreis oder eine Anpassungskomponente (23) beinhaltet, die mit der anderen Klemme des Stromkreises oder der regelbaren, symmetrischen Abgleichkomponente verbunden ist, wobei die Anpassungskomponente (23) und die regelbare, symmetrische Abgleichkomponente (11, 11', 11") Teil der beiden Stromkreise (12, 12', 12" und 5, 9, 10) sind und aus Kapazitäten bestehen und der Generator (21) kontinuierlich, intermittierend oder pulsierend, funktionieren kann.

16. Einspeisestromkreis nach einem der Ansprüche 1 bis 14, **dadurch gekennzeichnet, dass** der primäre Einspeisestromkreis (12, 12', 12") des mindestens einen der Schwingkreise (5, 9, 10) aus einem getrennten Stromkreis besteht und zusätzlich zu einem Hochfrequenz-Generator (21), der an die bestimmte Resonanzfrequenz des betroffenen Schwingkreises angepasst ist und des oder der Elements/e, die an der Kopplung mit mindestens einem der beiden Leiterabschnitte (4, 4'), die mit der Spule (2) eines oder der Leitungshauptabschnitte (3, 3') und dem Stromkreis oder der Abgleichkomponente (11, 11', 11") verbunden sind, teilhaben, auch einen Stromkreis oder eine Anpassungskomponente (23) umfasst, die dazu bestimmt ist, die Kopplung zu optimieren und bestimmte Effekte auf dem Niveau des primären Einspeisestromkreises zu begrenzen.

17. Einspeisestromkreis nach Anspruch 16, **dadurch gekennzeichnet, dass** die oder jede Kopplung [primärer Einspeisestromkreis (12, 12', 12") / betreffender entsprechender Schwingkreis (5, 9, 10)] eine im Wesentlichen magnetische Kopplung ist, und dass der Stromkreis oder die Anpassungskomponente (23) eine regelbare Kapazität ist, die zur Annulierung der induktiven Reaktanz auf dem Niveau des betrachteten primären Einspeisestromkreises liegt.

18. Einspeisestromkreis nach einem der Ansprüche 16 und 17, **dadurch gekennzeichnet, dass** der Energietransfer durch Kopplung zwischen dem primären Einspeisestromkreis (12, 12', 12") und dem verbundenen Schwingkreis (5, 9, 10) aus einer Doppelkopplung besteht und symmetrisch und äquivalent die Leiterabschnitte (4, 4'; 6, 6'), die den beiden betreffenden Abschnitten der Übertragungsleitung (3, 3' ; 8, 8' ; 7, 7') ähnlich sind, beeinflussen.

19. Einspeisestromkreis nach einem der Ansprüche 17 oder 18, **dadurch gekennzeichnet, dass** die oder jede der beiden Kopplung(en) [ primärer Einspeisestromkreis (12, 12', 12") / betreffender entsprechender Schwingkreis (5, 9, 10)], die den Energietransfer zwischen diesen beiden Stromkreisen realisieren, in einer im Wesentlichen magnetischen Kopplung zwischen einerseits einem Segment (24, 24', 24") eines Leiterabschnitts einer der Leitungsabschnitte (3, 3' ; 7, 7' ; 8, 8') des betrachteten Schwingkreises (5, 9, 10) und andererseits einem Segment gegenüber (25, 25', 25") der Leitung, das den Generator (21) mit der Anpassungskomponente (23) in dem verbundenen primären Einspeisestromkreis (12, 12', 12") verbindet, besteht, wobei die beiden Segmente von jedem dieser untereinander verknüpften Segmentpaare (24, 25 ; 24', 25' ; 24", 25") bestimmte Längen aufweisen und parallel und in der Nähe zueinander angeordnet sind, so dass sie Lecherleitungen bilden.

20. Einspeisestromkreis nach einem der Ansprüche 17 und 18, **dadurch gekennzeichnet, dass** die oder jede Kopplung zum Energietransfer [ primärer Einspeisestromkreis (12, 12', 12") / betreffender entsprechender Schwingkreis (5, 9, 10)] aus einer asymmetrischen oder symmetrischen, magneto-kapazitiven Kopplung besteht, zwischen einerseits einer Zylinderspule (26), die in Serie in den primären Einspeisestromkreis (12, 12', 12") geschaltet ist, und andererseits einer Kapazität(en)/Induktanz(en)-Anordnung, die in Serie in den betreffenden, verbundenen Schwingkreis (5, 9, 10) geschaltet ist, wobei die Kapazität mit der Abstimmungskomponente (11, 11', 11") wechselwirken kann und wobei die Induktanzen (27 und 27') zwei äquivalente Induktanzen umfassen können, die in Serie auf beiden Seiten der Abstimmungskapazität geschaltet sein können, wobei sie gegebenenfalls jeweils Teil eines LC-Stromkreises sein können.

21. Einspeisestromkreis nach einem der Ansprüche 1 bis 20, **dadurch gekennzeichnet, dass** der erste Schwingkreis (5) und/oder der mindestens eine zusätzliche Schwingkreis (9, 10) einen oder mehrere geeignete Band-Unterdrückung-Isolationsfilter (17, 17'; 18, 18'; 19, 19'), die gegebenenfalls auf die Resonanzfrequenz des anderen Schwingkreises oder der anderen Schwingkreise angepasst sind, umfassen.

22. Isolationsstromkreis nach Anspruch 21, **dadurch gekennzeichnet, dass** sich die Isolationsfilter in Form von Filterpaar(en) darstellen, die symmetrisch in dem betroffenen Schwingkreis angeordnet sind, wobei jeder Filter eines gegebenen Paares von Filtern in Serie geschaltet ist oder mit einem der Leiterabschnitte, die Teil des betroffenen Schwingkreises sind, in Serie geschaltet ist.

23. Einspeisestromkreis nach Anspruch 21 oder 22, **dadurch gekennzeichnet, dass** beim Vorhandensein eines ersten Schwingkreises (5) und zweier zusätzlicher Schwingkreise (9 und 10), in mindestens einem (10) der Schwingkreise zwei Paare von Isolationsfiltern (17, 17' ; 18, 18' ; 19, 19') integriert sind, wobei jedes Filterpaar auf die Resonanzfrequenz eines der beiden anderen Schwingkreise (5 und 9) eingestellt ist, wobei eines (19, 19') der Filterpaare mindestens hinsichtlich der Frequenz, vorzugsweise kontinuierlich, regelbar ist.

24. Einspeisestromkreis nach einem der Ansprüche 16 und 17, **dadurch gekennzeichnet, dass** die Isolationsfilter aus Paaren von LC-Stromkreisen bestehen, wobei in das Paar oder die Paare von Filtern (19, 19'), das/die gegebenenfalls hinsichtlich der Frequenz steuerbar ist/sind, fortlaufend variable Kapazitäten mit einem wechselseitigen mechanischen Steuergerät zu ihrer Steuerung (29) integriert sind.

25. Mehrfrequenz-NMR-Sonde, **dadurch gekennzeichnet, dass** sie mit einem Einspeisestromkreis (1) der Probenspule (2) nach einem der Ansprüche 1 bis 24 versehen ist.

26. NMR-Spektrometer, insbesondere für die Spektrometrie von festen Phasen, **dadurch gekennzeichnet, dass** es einen Einspeisestromkreis (1) der Probenspule (2) nach einem der Ansprüche 1 bis 24 aufweist.
